(19) Europäisches Patentamt

European Patent Office

Office européen des brevets

(11) EP 1 016 209 B1

(12) EUROPEAN PATENT SPECIFICATION

(45) Date of publication and mention
of the grant of the patent:
**11.06.2003 Bulletin 2003/24**

(51) Int Cl.⁷: $H03C\ 1/00$, H03C 5/00,
H03D 1/00, H03D 5/00

(21) Application number: **98940409.0**

(22) Date of filing: **27.08.1998**

(86) International application number:
**PCT/GB98/02583**

(87) International publication number:
**WO 99/010976 (04.03.1999 Gazette 1999/09)**

(54) **COMMUNICATIONS APPARATUS**

KOMMUNIKATIONSGERÄT

DISPOSITIF DE COMMUNICATION

(84) Designated Contracting States:
**AT BE CH CY DE DK ES FI FR GB GR IE IT LI LU
MC NL PT SE**

(30) Priority: **27.08.1997 GB 9718131**

(43) Date of publication of application:
**05.07.2000 Bulletin 2000/27**

(73) Proprietor: **Radioscape Limited**
**London NW1 7RE (GB)**

(72) Inventors:
• **FERRIS, Gavin Robert, Radioscape Limited**
**London NW1 7RE (GB)**
• **FLORENCE, Peter Charles, Radioscape Limited**
**London NW1 7RE (GB)**

(74) Representative: **Langley, Peter James et al**
**Origin Limited,**
**52 Muswell Hill Road**
**London N10 3JR (GB)**

(56) References cited:
**EP-A- 0 276 932**          **EP-A- 0 486 095**
**EP-A- 0 501 829**          **US-A- 4 977 607**
**US-A- 5 115 201**          **US-A- 5 357 221**
**US-A- 5 589 833**

• **PATENT ABSTRACTS OF JAPAN vol. 097, no.
003, 31 March 1997 & JP 08 297563 A
(YAMATAKE HONEYWELL CO LTD), 12
November 1996**
• **PATENT ABSTRACTS OF JAPAN vol. 095, no.
007, 31 August 1995 & JP 07 095175 A (TOSHIBA
CORP), 7 April 1995**

**EP 1 016 209 B1**

## Description

This invention relates generally to the field of radio frequency receivers and transmitters (which, when incorporated together in one unit are commonly referred to as 'transceivers'). The invention has particular application where such systems are connected to personal computing devices (PCDs), such as laptop PCs or personal digital assistants (PDAs).

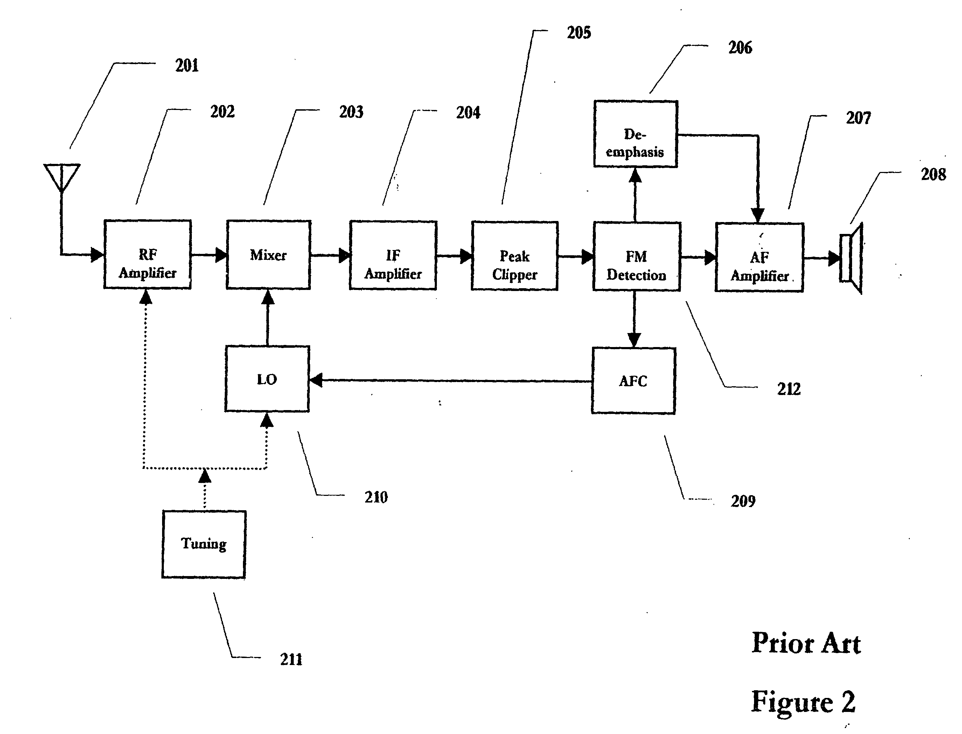

The use of radio frequency (RF) electromagnetic waves as a carrier for information, such as analogue audio, digital audio and general digital data, is well known in the communication art. The most familiar exploitation of this is found in television and radio, and a typical receiver for FM radio is shown (in block diagram form) in FIG. 2. In such a receiver, an antenna 201 converts radio frequency electromagnetic radiation (RF) into electrical signals. Since the antenna will convert (to some degree) any RF, some means is needed to select only the desired signal, which, in the case of conventional FM audio broadcasting, will be a particular band of signals with a particular centre frequency and a 200kHz bandwidth. This process is known as tuning, and the degree to which a receiver is able to acquire only the desired signal and reject all others is known as its selectivity. The RF amplifier 202 provides some degree of tuning selectivity, commonly through the use of resonant (LC) circuits on its input and output. The resonant frequency of these circuits is set by the tuning control 211, which will commonly involve variable capacitors. The RF amplifier 202 also increases the system's sensitivity (i.e., its ability to acquire weak RF signals), by increasing the amplitude of the signal.

To provide a well controlled receiver bandwidth and to reduce the frequency of the acquired RF signal, the signal is next passed into a mixer 203, where it is combined with a signal from a local oscillator (LO) 210. The frequency of oscillator 210 is set by the tuning control of the device 211 (and modified by feedback from the automatic frequency control (AFC) system 209). The result of such RF/LO mixing, commonly referred to as heterodyning, is to produce the sum and difference of the LO and RF frequencies (together with a number of other frequencies). If these frequencies are denoted $f_o$ and $f_r$ respectively, then the primary output of mixer 203 will be $|f_r \pm f_o|$. In high side injection, which is most usual in such receivers, the $f_o$ signal is higher in frequency than the desired frequency $f_r$. The difference between them is set to be the intermediate frequency, or IF, by the tuning control 211. If we denote this frequency $f_i$, then:

$$f_o = f_r + f_i$$

The purpose of this arrangement is to down-convert the inbound RF signal $f_r$ to a fixed frequency (for that receiver) $f_i$, which is then selected by the tuned IF amplifier 204. Because the frequency $f_i$ is fixed, the bandwidth of the receiver can be accurately controlled, and the IF amplifier therefore provides good selectivity of the $f_r$ - $f_o$ IF signal. Systems such as that illustrated in FIG. 2 are commonly referred to as superheterodyne (or superhet) receivers. The terms are contractions of "supersonic heterodyne" because they generate a beat signal at frequencies above human hearing.

Care has to be taken with such an arrangement, however, to prevent the receiver from picking up another, unwanted signal, known as the image frequency. This occurs because the system accepts the signal $f_{im} = f_r + 2 f_t$, on which it will operate to produce (*inter alia*):

$$f_{im} - f_o = (f_r + 2 f_i) - (f_r + f_i) = f_t.$$

In simple systems such as that illustrated in FIG. 2, good image rejection is normally achieved by the tuned RF amplifier 202 suppressing $f_{im}$.

The IF signal (which is normally set to $f_i$ = 10.7MHz for conventional FM audio receivers) is then passed into a peak clipper 205, which simply conditions the signal (by eliminating amplitude changes due to noise) prior to the action of the detector 212. The detector or demodulator, for frequency modulation (FM) converts changes in the frequency of the carrier wave $f_r$ (now represented by in downconverted IF form as $f_i$) to changes in amplitude of the original, modulating wave $f_m$. The primary result of stage 212, therefore, is the recovered audio information, which is passed to an audio frequency amplifier 207 and then on to a reproducer, in this case a speaker 208 which renders the recovered audio information in audible form. Two other supplementary systems are linked to the detector. One. the automatic frequency control (AFC) 209, is fed back to the oscillator to prevent $f_o$ from drifting. Another, the de-emphasis network 206 modifies the received signal to compensate for the pre-emphasis (treble boost) used in FM transmission, by reducing the strength of the higher-frequency components of the audio signal.

In all of the above discussion, it should be noted that although the RF carrier centre frequency and the local oscillator frequency $f_o$ are single frequency signals, the frequency of the modulating wave $f_m$ and the resulting transmitted wave $f_r$ will generally vary over time (with changes in the amplitude envelope of $f_m$ altering the carrier frequency, for FM). The difference between the maximum and minimum frequencies of the modulating signal $f_m$ is known as the modulation bandwidth.

In general, modulation operates by shifting one or more of the frequency, phase or amplitude of a carrier wave (or set of such carriers) in accordance with the modulating signal's instantaneous amplitude. This process creates sidebands around the central carrier frequency, and the difference between the highest frequency significant sideband and the lowest frequency significant sideband is known as the transmission bandwidth. The complementary process to modulation, which takes place at the receiver side to recover the modulating signal is known as demodulation.

A large number of modulation schemes may be used to transmit information via RF emissions, and those well known in the art include frequency modulation (FM), various forms of amplitude modulation (AM) (such as full carrier double sideband, suppressed carrier double sideband, and suppressed carrier single sideband), and phase modulation (PM); and these techniques may be applied jointly (as with quadrature amplitude modulation or QAM, which combines amplitude and phase modulation), and in parallel across a number of carriers (as, for example, with the coded orthogonal frequency division multiplex (COFDM) used in the Digital Audio Broadcasting system, defined in ETS 300 401 rev. 2). The situation is further complicated by the emergence of spread spectrum techniques, such as code division multiple access (CDMA), which uses a wide transmission bandwidth that is shared by various transmitting stations, each of which makes use of a unique code sequence to allow the signal to be distinguished from that of the other stations.

Fixed demodulation receivers, such as that shown in FIG. 2, are capable of only a single demodulation scheme. More advanced receivers can demodulate according to a number of schemes. For example, a household radio will normally be capable of demodulating conventional FM and AM, and will also be able to operate across a number of different frequency bands. Yet more sophisticated communications receivers, often referred to as 'scanners', generally implement a large number of demodulation schemes, and can acquire signals over a very wide range of RF frequencies. However, even sophisticated scanners are limited, in that they cannot easily be adapted to demodulate signals using modulation schemes that are introduced after they are manufactured.

FIG. 4 shows an overview of a system proposed by Rosetta Labs in WO 9627949, in which a personal computing device (PCD) 405 is connected to a communications receiver 401 via an interface 402. The PCD 405 displays a man-machine interface (MMI) 403 through which the user can select the tuning and demodulation options for the receiver 401, said information being transmitted to the receiver through the interface 402. The PCD 405 can receive demodulated digital information from the device and then display the information using the MMI. It can also receive general tuning information, and signal summary information, such as an indication of the received signal strength (RSSI). Note, however, that with this system the PCD is only acting as a sophisticated tuning controller and reproducer - the demodulation is still performed in a dedicated hardware receiver 401.

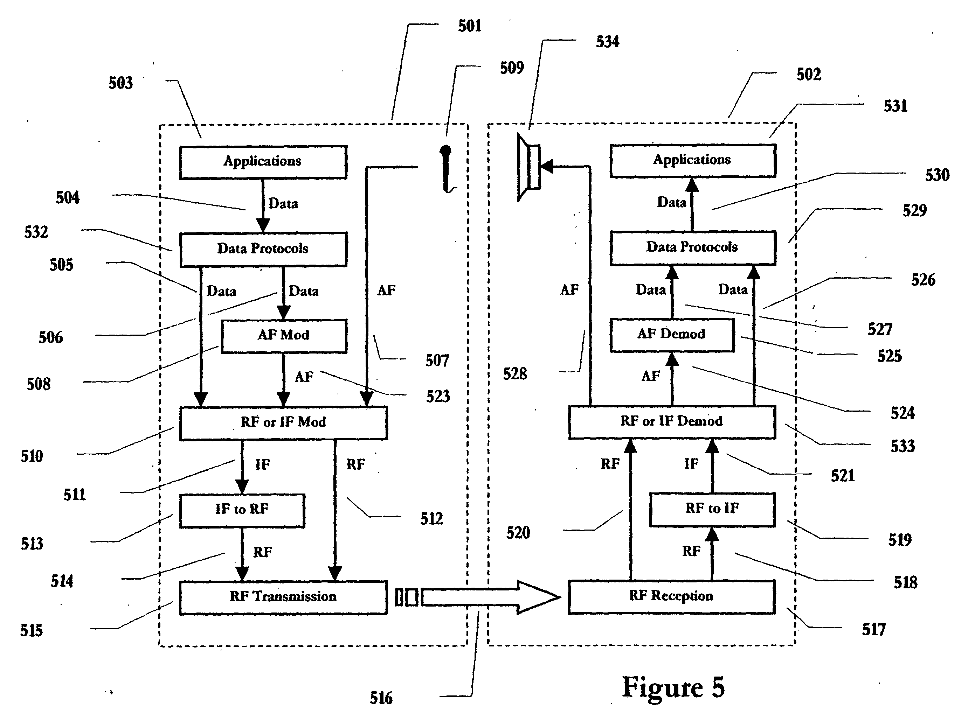

FIG. 5 illustrates the mechanisms used in the transmission and reception of intelligence by RF, as known in the communication arts. At the transmission side 501, an originating application 503 generates digital data 504, which is then transformed through a number of digital protocols 532. These protocols may serve a number of different functions, and are commonly arranged in a protocol stack which may be analysed according to the middle layers (2 through 6) of the Open Systems Interconnect model proposed by the International Standards Organisation (ISO/OSI).

| |
|---|
| 7 – Application Layer<br>Connection to PCD applications |
| 6 – Presentation Layer<br>Formatting transforms for data (file conversions, etc.) |
| 5 – Session Layer<br>Persistent connection management |
| 4 – Transport Layer<br>Safe end-to-end communication |
| 3 – Network Layer<br>Addressing, routing and switching across a network |
| 2 – Link Layer<br>Link-based error detection and correction |
| 1 – Physical Layer<br>How bits are sent and received |

For example, session control (layer 5) could occur here, as could forward error control, such as convolutional encoding and the addition of checksums (layer 2). However, the important thing in the present case is that the result of the high level data protocols 532 is digital data 505/506, ready for transmission.

The next stage is to pass the data into a modulator, in order to encode it onto a signal suitable for tranmission at RF. This can be done in a number of ways. The first, commonly used by systems which must send data over an existing analogue transmission system originally intended for audio (such as a voice-based telecommunication system), provides an audio frequency (AF) modulator 508 which renders the data into AF 523, which is then passed on to a subsequent, higher frequency modulation stage 510, in much the same way as AF 507 coming from a conventional audio source (such as a microphone 509) would be. The second (and generally more efficient) way to proceed is to pass the data 505 directly to the modulator 510, and then use an appropriate scheme (such as QAM) to encode it.

The information can be encoded either directly to RF signal 512 by the modulator 510, or encoded by the modulator 510 to IF signal 511, which may then be up-converted (by 513 which will commonly involve a single or multiple superhet) to RF signal 514. In any case. after the modulator stage 510 the information is generally embodied in analogue form.

The RF signal 512/514 is conveyed into the RF transmission subsystem 515 which provides the necessary buffering, matched emission antenna and so on. The information is then propagated through space as electromagnetic waves 516.

These waves may be acquired by a remote receiver station 502, using an appropriate RF front end 517 (reception antenna, RF amplifier etc.). The result is electrical RF signals 518/520, which, depending on the receiver, may either be directly passed 520 to the demodulator 533, or passed 518 to a down-converter stage 519 (which will commonly involve a single or multiple superhet), in which it is shifted to an intermediate frequency (IF) 521 and then passed to demodulator 533.

In any event, the (generally analogue) RF 520 or IF 521 signal enters the demodulator 533, where it is detected. In the case of analogue audio intelligence, the detected AF signal 528 may (after amplification) be passed to a reproducer 534 (such as a speaker) which allows the original audio to be heard. In the case of digital data encoded within an AF signal, the recovered intelligence 524 is passed to an AF demodulator 525, which is used to recover the low-level data stream 527. For directly encoded data, the demodulator 533 produces the data stream 526. In either case, the data is then passed 526/527 to higher-level, digital data protocols 529, which perform operations corresponding to the middle layers of the ISO/OSI model. The resulting data 530 is then passed to end-user applications 531.

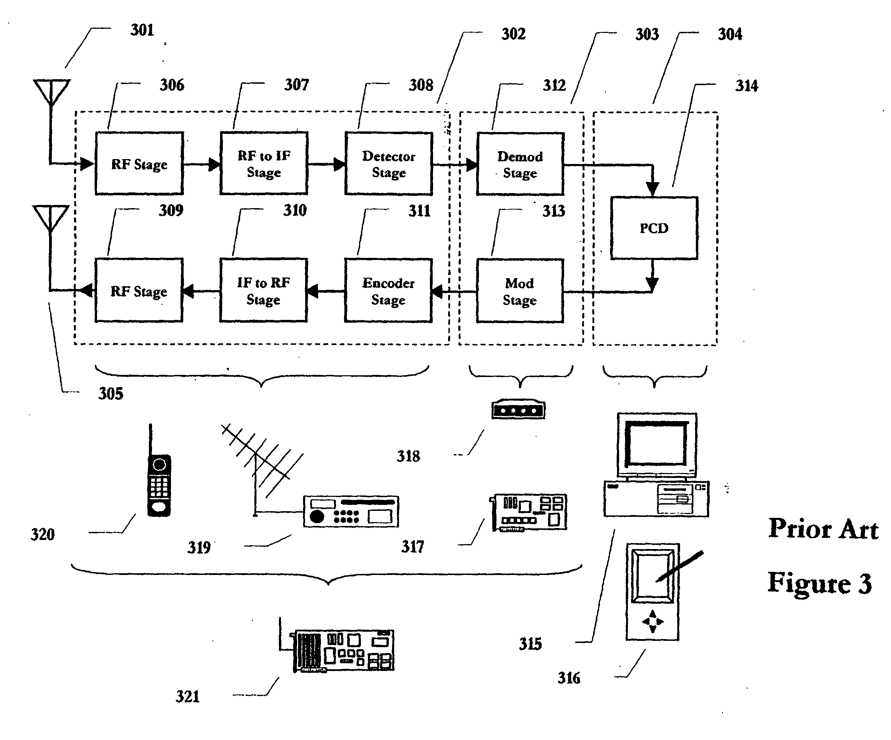

Turning now to FIG. 3, we can see how, in the prior art, this arrangement for data transmission outlined in FIG. 5 has conventionally been implemented. Consider first the case of an inbound, or forward channel signal. Generally, an antenna 301 is used to convert electromagnetic RF emissions into electrical signals at RF frequency, which are then amplified and subjected to coarse selection by an RF receiver stage 306 (these two stages correspond to 517 in FIG. 5), then brought down to an intermediate frequency (IF) by a down-converter stage 307 (commonly implemented as a single or multiple superhet, corresponding to 519 in FIG. 5) before being subjected to a detector stage 308, which . provides the primary demodulation to digital information (or AF), corresponding to 533 in FIG. 5. These three stages 302 are commonly implemented in a single device, such as a cellular telephone 320 or communications receiver 319. The resulting decoded information, corresponding to 526/524 from FIG. 5, is then passed to a higher-level system, which in the case of AF provides secondary demodulation (as per 525 in FIG. 5) and in both cases provides much of the higher level data protocols (529 in FIG. 5). This stage 303 is generally provided by a plug-in hardware card 317 or an external modem 318, and since it deals with digital or AF input the processes it performs do not directly depend upon the data having been sent over a radio link. The functions of both 302 and 303 are sometimes combined on a single plug-in card 321. The resulting data stream is then passed to the personal computing device (PCD) 314 where it is consumed by applications (this corresponds to 531 in FIG. 5). At this stage 304 the device in question is generally a personal computer, such as an IBM-compatible PC 315, a 'personal digital assistant' (PDA) 316, or otherwise.

A similar analysis may be made for the generation of an outbound signal (or back channel). Applications on the PCD 314 supply information (corresponding to 503/504 in FIG. 5), which is then passed to a high-level protocol/ modulation stage 313 in device 303, responsible for mapping the data through the appropriate protocols (as per 532 in FIG. 5), and possibly transforming it into AF (this corresponds to 508 in FIG. 5). As with input, the transformations in device 303 do not necessarily produce a signal that is specific to transmission over a radio link, since the intelligence is either AF or a direct digital representation on exit. (For example, if rendered to AF, a conventional land-line telephone system could be used to send the modulated information to a remote terminal).

The AF or digital signal is then passed into the radio communications device 302 which encodes the signal (generally to analogue IF; in any event corresponding to the modulator 510 of FIG. 5), up-converts it 310 (generally using a single or multiple superhet arrangement, corresponding to 513 of FIG. 5) and then passes it to an RF amplifier 309 and antenna 305 which emit the final signal (these two corresponding to 515 in FIG. 5). The mapping to physical devices is the same for transmission as reception (other than the obvious requirement that the device, be it communications receiver 319, all-in-one radio modem card 321 or otherwise, have RF transmission capabilities in addition to the reception mechanisms just mentioned). It is much more common in such prior art system to find a transceiver or receiver-only implementation - transmitter-only implementations are fairly rare.

In the prior art, the use of special hardware, such as digital signal processor integrated circuits (DSP ICs) or analogue detectors (such as a ratio detector for FM demodulation) have conventionally been employed. However, DSPs are expensive to produce, expensive to customise for a particular application (since few engineers have experience of them), and difficult to update in the field to cope with new modulation schemes. Analogue detection circuitry, on the other hand, tends to be extremely inflexible, and cannot cope with the emerging breed of complex, and primarily digital, transmission protocols. For example, the coded orthogonal frequency division multiplex / differential quadrature phase shift keying (COFDM/DQPSK) modulation of the ETSI Digital Audio Broadcasting (DAB) specification (standard ETSI 300 401 rev. 2), is quite beyond the scope of analogue decoders.

There is a generally acknowledged need to provide inexpensive, flexible access to high-bandwidth RF wireless data services, including both forward and back channels, to users of PCDs. However, prior art PCD radio modems, such as 321 in FIG. 3, are generally either very expensive, due to the use of DSP ICs, or unable to transceive at high data rates (because they make use of simple, analogue systems such as binary frequency shift keying (BFSK), and therefore cannot take advantage of modern high-throughput schemes such as COFDM/QPSK or COFDM/QAM). In either case, such modems are generally inflexible - they are designed to handle only one (or a small number) of modulation schemes and RF frequencies, and furthermore, generally do not provide forward compatibility - adapting an existing RF modem to a new communications protocol usually means buying a new modem, or having an troublesome hardware upgrade performed on the device.

EP-A-0 276 932 relates to a satellite receiver module using a computer for control of the signals. The receiver module has a circuit which is adapted to process signals from the satellite and to cooperate with a computer.

US-A-5 589 833 discloses a radar acquisition system providing high frequency radio transmission, in which the intermediate frequency signal is digitized and handled by a personal computer bus interface card.

It is, correspondingly, an object of the current invention to provide an RF communications apparatus, intended for use with a PCD and a suite of software running thereon, which provides an economical communications system that can easily be adapted to different modulation and demodulation schemes.

According to a first aspect of the present invention, there is provided communications apparatus comprising means for receiving a modulated radio frequency signal, at least one means for down-converting a received modulated radio-frequency signal to an intermediate frequency, means for digitising a down-converted signal and means for exporting at least a part of the digitised modulated signal to a personal computing device in which the personal computer comprises a main processor programmed to perform demodulation of the digitised modulated signal.

According to a second aspect of the present invention, there is provided communications apparatus comprising means for importing a digital modulated signal from a personal computing device, modulation to generate the digital modulated signal at an intermediate frequency having been performed by a main processor in the personal computing device, means for converting the digital modulated signal to an analogue signal, means for up-converting the analogue signal to a radio frequency signal and means for transmitting the radio frequency signal.

The subject-matter of Claim 1 and 18 differs over EP-A-0 276 932, in that the digitised signal exported to or imported from the personal computer are digitised modulated signals, and that the personal computer comprises a main processor programmed to perform demodulation of the digitised modulated signal or to perform modulation to generate the digitised modulated signal, respectively.

In a broad sense, the invention is designed to exploit the extremely fast main processor integrated circuits (ICs) and large memory capacity available within PCDs, particularly IBM-PC compatible machines. The processor chips fitted to such systems are often capable of outperforming dedicated digital signal processing (DSP) ICs, and have plenty of spare computing capacity (and other resources, such as memory) available when the user is performing the tasks for which PCDs are commonly employed, such as editing a spreadsheet, writing a letter, browsing files, and suchlike. The cost of the said main processor IC is high, but the user has already paid for the device when he or she bought the PCD (unlike the case of the DSP, which must be included in the price of a DSP-equipped radio modem). In any case, the extremely large and competitive market for PCDs means that the cost per normalised computational operation (NCO) is lower for the main processor IC than the dedicated DSP. Furthermore, the ubiquity of such ICs ensures the existence of a large number of software engineers who are familiar with coding for such architectures, and the presence of advanced development tools to facilitate their efforts. This must be compared with the specialised world of DSP programming, with all its attendant expenses.

The present invention thus exploits the availability of 'spare' computing capacity on the very device to which the user wishes to connect a radio receiver, transmitter or transceiver (in order to gain access to information services and other RF broadcasts, whether analogue or digital). It is thus beneficial to make use of this capacity, rather than to replicate it by embedding an expensive DSP into the transceiver hardware (or to use a restricted analogue component system). One of the key advantages of the present invention is that it provides the ability to do this, incorporating a communications receiver, transmitter or transceiver 'front end' to a digital IF data pump, which is capable of communicating with adaptable software drivers in the PCD over a high speed data bus. The drivers are responsible for converting the digitised IF to the modulating data contained therein, and for synthesising digital IF representing the modulated components of any outgoing transmission. The ability to use PCD-resident software, and PCD main processor cycles, to process the IF information (whether inbound or outbound) is a key feature of the common invention. It allows the device to be manufactured at a relatively low cost, yet be able to process complex, high-bandwidth RF signals (with a correspondingly high bit throughput), be capable of handling a wide variety of modulation protocols, and be easily extendible to cope with new (or modified, or previously unaddressed) modulation protocols, with the simple addition of 'plug-in' software modules on the PCD.

Other optional features of the present invention will be apparent from the attached dependent claims.

The present invention will now be described by way of example with reference to the accompanying drawings, in which:

FIG. 1 is a functional block diagram showing the major components of one embodiment of the radio frequency (RF) adaptor of the present invention. As is the case with all the drawings, only the major control and data flows are shown; minor control and data flows are not.

FIG. 2 is a functional block diagram of a frequency modulation (FM) receiver for conventional audio broadcasting, as is known in the prior art.

FIG. 3 is a functional block diagram showing the connection between a radio frequency receiver a hardware modem, and a personal computing device (PCD), as is known in the prior art. Examples of systems embodying the various stages are also shown.

FIG. 4 is a functional block diagram of an RF scanning radio controlled by a PCD, as is known in the prior art.

FIG. 5 is a conceptual protocol stack diagram, illustrating the end-to-end process of content transmission and reception using RF signals.

FIG. 6 is a functional block diagram of the Antenna Control Unit of the RF adaptor of the current invention (corresponding to 103 in FIG. 1), according to a preferred embodiment.

FIG. 7 is a functional block diagram of the radio frequency (RF) reception amplifier stage of RF adaptor of the current invention (corresponding to 104 in FIG. 1), according to a preferred embodiment.

FIG. 8 is a functional block diagram of the down-converter stage of the RF adaptor of the current invention (corresponding to 105 in FIG. 1), according to a preferred embodiment.

FIG. 9 is a functional block diagram of the (inbound) anti-aliasing bandpass filter unit of the RF adaptor of the current invention (corresponding to 106 in FIG. 1), according to a preferred embodiment.

FIG. 10 is a functional block diagram of the analogue to digital converter (ADC) unit of the RF adaptor of the current invention (corresponding to 107 in FIG. 1), according to a preferred embodiment.

FIG. 11 is a functional block diagram of the interface management unit (IMU) of the RF adaptor of the current invention (corresponding to 108 in FIG. 1), according to a preferred embodiment.

FIG. 12 is a functional block diagram of the digital to analogue converter (DAC) unit of the RF adaptor of the current invention (corresponding to 110 in FIG. 1), according to a preferred embodiment.

FIG. 13 is a functional block diagram of the (outbound) anti-aliasing bandpass filter and combiner of the RF adaptor of the current invention (corresponding to 111 in FIG. 1), according to a preferred embodiment.

FIG. 14 is a functional block diagram of the up-converter stage of the RF adaptor of the current invention (corresponding to 112 in FIG. 1), according to a preferred embodiment.

FIG. 15 is a functional block diagram of the RF transmission amplifier stage of the RF adaptor of the current invention (corresponding to 113 in FIG. 1), according to a preferred embodiment.

FIG. 16 is an exploded diagram showing an embodiment of the RF adaptor of the current invention fitted as an internal card (such as a PCI card) within a personal computing device (PCD).

FIG. 17 is a rear view of a personal computing device (PCD), showing how two different embodiments of the RF adaptor of the current invention may be connected; one via a high-speed parallel bus (such as the SCSI bus) and the other via a high speed serial link (such as the USB).

FIG. 18 is a three-quarter view of a portable personal computing device (PCD), showing how an embodiment of the RF adaptor of the current invention, in the form factor of a PCMCIA card, may be fitted to said PCD.

FIG. 19 is a functional block diagram of the software driver structure which exists on the personal computing device (PCD) to which the RF adaptor of the current invention is fitted, according to a preferred embodiment.

FIG. 20 is a functional block diagram showing the major components of one embodiment of a simple radio frequency (RF) receiver adaptor of the present invention.

FIG. 21 is a flowchart showing how a simple demodulation process (in this case, of a signal modulated using binary frequency shift keying) may be performed by driver software running on the personal computing device (PCD) to which the RF adapter of the current invention is fitted, according to a preferred embodiment. Only the physical layer of the ISO/OSI model is shown.

FIG. 22 is a flowchart showing how a simple modulation process (in this case, using binary frequency shift keying) may be performed by driver software running on the personal computing device (PCD) to which the RF adapter of the current invention is fitted, according to a preferred embodiment. Only the physical layer of the ISO/OSI model is shown.

In the following text, a detailed description will be given of the various component parts of the preferred embodiment of the RF adaptor of the current invention.

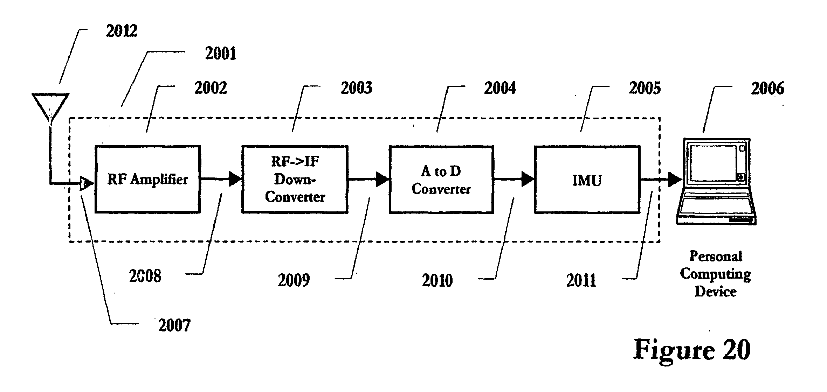

A very simple, fixed centre frequency, receiver-only embodiment of the RF adaptor of the current invention is shown in Fig. 20. An antenna 2012 acquires RF transmissions and feeds them into the device 2001 as electrical signals 2007. There, the signals are amplified and subjected to a degree of frequency selection by an RF amplifier 2002. The resulting amplified RF signal 2008 is then passed to a down-converter 2003, which, using a fixed frequency local oscillator superhet arrangement, selects the appropriate bandwidth signal and shifts it down in nominal centre frequency to a low intermediate frequency (IF) signal. This IF signal 2009 is then passed into an analogue to digital converter unit 2004 where it is passed through an anti-aliasing filter and then digitised. The resulting digital data stream 2010 is passed to an interface management unit (IMU) 2005, which controls access to a high speed bus 2011, through which the (still modulated) digitised IF signal is passed into the personal computing device (PCD) 2006. As the data is received into the PCD 2006 it is processed by software modules contained therein to provide demodulation and higher level data processing. The demodulated data is then either stored or presented to a user.

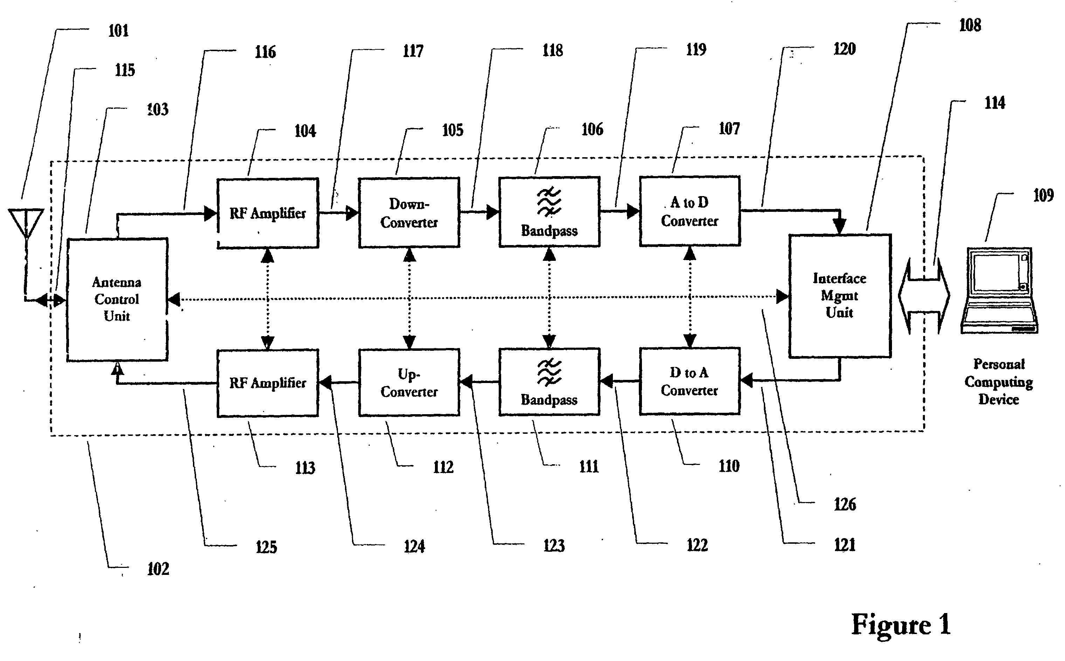

The overall scheme of operation for a more complex system, capable of both transmission and reception, and able to operate over a number of different nominal centre frequencies and bandwidths, may best be appreciated with reference to FIG. 1 (a high-level block diagram showing the major components of one embodiment of the RF adaptor device 102 of the current invention). In the system. RF signals are acquired by the antenna 101, and passed 115 into an antenna control unit 103, which provides various matching, switching and diversity functions, and provides IF traps to protect against IF breakthrough. The resultant RF signal 116 is then passed into an RF amplifier 104, which provides a degree of selectivity (variable, tuned response) and sensitivity (by boosting the RF signal strength). The amplified RF signal is not amenable to direct digital processing however, since it will often be at 100s of MHz, which is well above the ability of current PCD processor ICs and data transfer busses, not to mention analogue to digital converters (ADCs). Since the bandwidth of the signal is what is important, however, and not the nominal centre frequency at which it is transmitted, the RF signal 117 is next passed into a down-converter 105, which translates the desired frequency band to an appropriate intermediate frequency (IF). The down-converter also provides additional selectivity and amplification of the desired signal.

The IF signal 118 is then passed into a bandpass filter system 106, the primary purpose of which is to restrict the higher frequency components of the signal, to prevent aliasing of the signal captured by the analogue to digital converter (ADC) 107, into which the filtered IF signal 119 is next passed. The purpose of the high speed, high precision ADC unit 107 is to render a digital, sampled version of the IF waveform, which is then amenable to further digital processing. The digitised data stream is passed (on a continuous basis) across data bus 120 to the interface management unit (IMU) 108. The purpose of the IMU is to manage all system functions within the device, and to control the flow of data between the device 102 and the PCD 109. Inbound, the digitised IF signal is buffered within the IMU and transferred to the PCD 109 as appropriate, using a fast bus 114.

The inbound, digitised IF signal is then processed by software modules within the PCD 109, making use of the aforementioned spare capacity (as and when available) on the PCD's main processor IC (or ICs). These modules demodulate and decode the IF signal, and provide any higher level protocol handling (including secondary, AF demodulation if needed) that may be necessary. Data thus recovered may be used by applications running on the PCD, or passed along to other systems as desired.

When data is to be transmitted from the PCD 109 by the device 102, the software modules running on the PCD 109 must first perform any necessary encoding and modulation (including high level data protocols, and initial AF modulation if desired), thereby yielding a synthesised digital IF signal. This information is passed via the high speed bus 114 to the IMU 108, where it may be buffered before being streamed 121 to a high speed, high precision digital to analogue converter (DAC) unit 110. This converts the digital IF signal into an analogue representation 122, which must then be sent through an anti-aliasing filter 111, the primary purpose of which is to remove unwanted high frequency components which are a natural by-product of the digital to analogue conversion process. The filtered IF signal 123 is then passed into an up-converter unit 112, which shifts it upwards in nominal centre frequency to the appropriate range for transmission (which will, of course, vary depending on the service in use). The up-converter also provides signal amplification and selectivity at the IF range.

The resulting up-converted RF signal 124 is passed into the (outbound) RF power amplifier 113, which increases its strength to a level appropriate for transmission. This amplified signal 125 is then passed to the antenna control unit 103, where it is connected to the appropriate antenna 101 for transmission. The antenna 101, which may be shared with the receiver antenna or distinct from it, then emits the RF signal as electromagnetic waves. and the cycle is complete.

The device is capable of receiving and transmitting information over a wide number of nominal centre frequencies and signal bandwidths. Control information affecting the frequency and bandwidth selectivity of the device is generated by the drivers on the PCD 109, under ultimate control of a man-machine interface (MMI). This information is conveyed to the IMU 108 over the data bus 114, and is then relayed by the IMU 108 to the various other component modules of the device 102 over the control bus 126. This bus is also used to transmit performance information (such as signal strength indications and tuning feedback) from the modules to the IMU 108, and between the modules themselves.

The device is capable of operating in a full duplex mode (simultaneous receive and transmit), as well as half duplex (receive and transmit, but never at the same time) and simplex (only either receive or transmit, but not both). Outbound transmissions can have a completely different modulation scheme, bandwidth and nominal centre frequency from the received signals, if desired. The device 102 is also able to 'scan' through various bandwidths and frequencies. Alternatively, or in addition, 'scanning' through modulation schemes may take place at the PCD 109 side, to acquire a signal of interest. Note that the system can also process digital tuning information contained (as digital intelligence) within the inbound signal, to allow it to effect a frequency (and possibly modulation) transition to 'follow' the transmission, which is useful for channel-hopping schemes (and for 'handovers' between services, for example DAB (Digital Audio Broadcasting) and conventional FM).

As will be appreciated, the device 102, connected to a PCD 109 as per the above description (and as discussed in greater detail in the following text) provides a unique low cost, high value RF transceiver system although the receiver and transmitter may be provided independently. This system is very flexible, and may be made compatible with future modulation standards through changes to the PCD software. It can operate on wideband and narrowband transmissions, and can (with the appropriate software drivers) receive and transmit single carrier. multiple carrier and spread spectrum signals.

The various components of the preferred embodiment of the RF adaptor of the present invention will now be discussed in more detail.

ANTENNA CONTROL UNIT

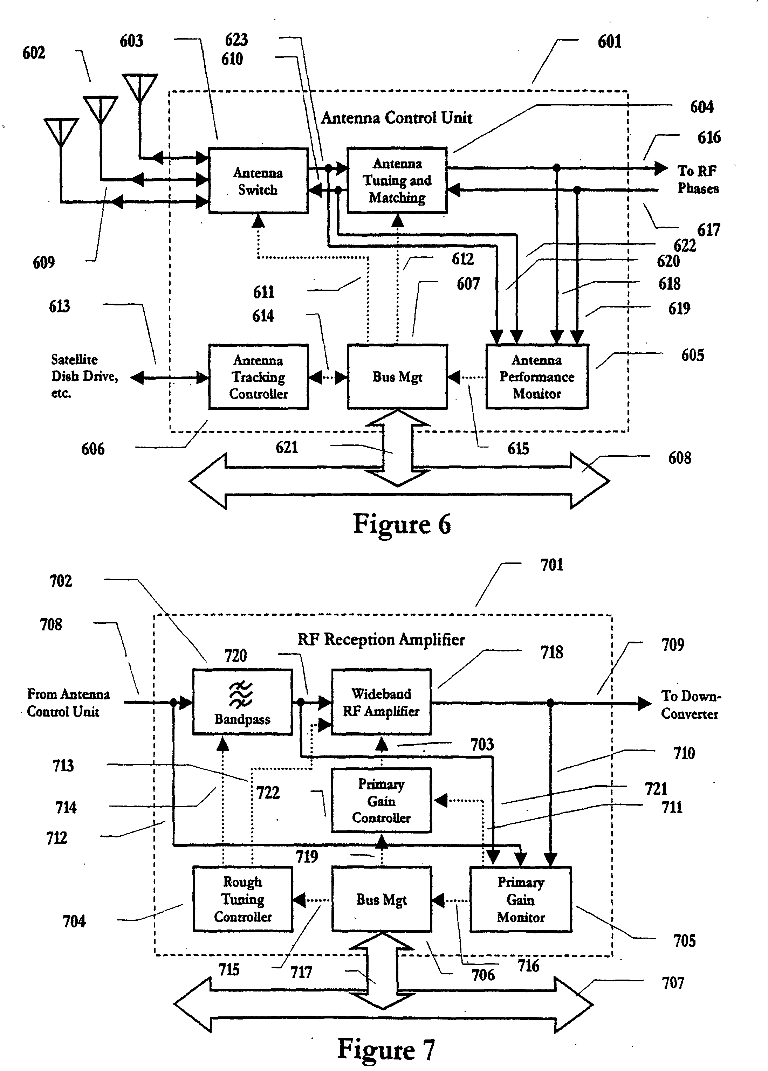

The first such component is the antenna control unit. corresponding to 103 in FIG. 1, and shown in greater detail in FIG. 6. This subsystem 601 is responsible for managing the connection of the various RF amplification stages of the transceiver (both receive and transmit) to a set of antennae 602. The purpose of any given antenna in the set 602 is to convert outbound RF electrical signals into RF electromagnetic emissions, and inbound RF electromagnetic emissions into RF electrical signals. The antenna switch 603 selects which antenna from the set 602 is to be connected to the RF outbound signal path 610 and/or inbound signal path 623. This system allows a single antenna to be shared for transmission and reception, either in a half-duplex switchover mode, or in a mixed signal mode, and also provides the basis of a multiplexed antenna diversity system. The switch is (ultimately) controlled by the operating mode selected by the end user and conveyed to the PCD system (109 in FIG. 1) via a MMI, this information being translated into an antenna switching profile by the driver software (discussed later), which communicates it to the interface management unit (108 in FIG. 1), which in turn issues low-level commands to the antenna switch 603 through the control bus 608. Within the antenna subsystem, a bus management unit 607, co-ordinates the main flow of information between subsystem components and the main feed onto and from the command bus 621.

The antenna tuning and matching unit (ATMU) 604 provides a number of functions. Its primary purpose is to couple the selected antenna or antennae from the set 602 to the rest of the system in an efficient manner. In the preferred embodiment, this system will include switchable baluns. a variable IF trap (consisting of a set of parallel resonant circuits, or equivalent surface acoustic wave or crystal filters. tuned to the IF frequencies injected elsewhere in the receiver, connected between each chosen antenna and earth), and other systems as are well known in the art to tune a particular antenna to receive or transmit within a particular frequency band. It also provides a degree of transient isolation between the antenna set 602 and the rest of the system. Control input is passed to the ATMU 604 via the command bus 608 and hence through control line 612, which will allow selection of different baluns, IF filter rejection profile, and so on.

The ATMU 604 is connected to the RF reception and transmission parts of the system, via an inbound 616 and an outbound 617 line. Feeds taken off the 'raw' signals to and from the ATMU 618 and 619 are passed to the antenna performance monitor 605, which also receives inputs of the signals 623 and 610. The performance monitor is responsible for determining metrics of the degree of 'match' that has been attained between the chosen antennae set and the signal feeds to and from the rest of the system, such as the voltage standing wave ratio (VSWR). These metrics are also used to provide safety switching, closing off the transmission system when no antenna is available (because the user has disconnected it, for example). Information from the antenna performance monitor is fed back 615 onto the control bus 608, where it will be used by the interface management unit (and higher level software in the PCD) to make quality of service and antenna matching and switching decisions.

Finally within this subsystem, the optional antenna tracking controller 606 is used for those antenna which have electronically controlled variable reception capabilities. For example, a satellite dish system might have the capability to move the dish through a particular sweep, and this functionality would be controlled through the antenna tracking controller. As another example, external antenna systems with built-in amplifiers would have their gain controlled through this system. In one embodiment, the tracking controller is an input/output IC, with lines 613 that can be programmed, modified and interrogated by high-level drivers running on the PCD, via the control bus 614. This arrangement allows the flexibility to extend the system to control many types of antenna and primary signal acquisition systems.

RF RECEPTION AMPLIFIER

The inbound signal 616 is passed from the antenna control unit 601 to the RF reception amplifier, corresponding to 104 in FIG. 1, and shown in detail in FIG. 7. The RF electrical signal 708 into the amplifier subsection 701 is first subjected to an electronically controlled bandpass filter, 702, which provides a first rejection of signals outside the desired band. This filter may be switched out of circuit entirely when desired (for very weak signals). The resulting filtered signal 720 is then subjected to the wideband radio frequency amplifier 718. The amplifier may be tuned to provide some degree of selectivity towards the inbound signal 720, and to suppress the formation of undesired image, cross-modulation and intermodulation products within the subsequent down-conversion stage; generally, this will be provided by a post-amplification bandpass filter incorporated within the unit 718. The centre frequency and bandwidth of the bandpass filter 702, and the coarse tuning provided by the RF amplifier 718, are selected by the rough tuning controller 704, through interface lines 714/713. This tuning is ultimately under the control of the MMI on the PCD, which then, through the appropriate software driver modules, sends tuning commands to the IMU, which in turn sends commands via the control bus 707 to the RF reception amplifier 701 (inter alia). Within the amplifier subsystem 701, the bus management unit 706 manages the flow of information to and from 717 the control bus to components of the subsystem, including the aforementioned tuning control (via 715).

The amplifier unit itself 718 consists, in one embodiment, of a set of switchable amplifiers, each with a distinct 'fingerprint' of bandwidth, gain, frequency and phase response. In such a system, the appropriate amplifier is switched into circuit by the rough tuning controller 704. In the preferred embodiment of the system, however, a single, relatively wideband amplifier is used, with tuning effected by an integral digitally controlled bandpass filter unit managed by the rough tuning controller 704 through line 713.

Of course, a primary purpose of the RF amplifier is to provide a degree of signal gain. At nominal reception frequencies below around 3MHz, the amplifier will be set to have very low gain (or be switched out of circuit altogether), because the overall signal-to-noise ratio (SNR) will not be improved by amplification. At higher frequencies, the noise picked up by the antenna (relative to the noise generated in the receiver) falls, making RF amplification worthwhile from an SNR point of view. Overall level optimisation to subsequent subsections of the transceiver, particularly the down-converter, is achieved by setting the appropriate gain. This is managed by the primary gain controller 722, which has a coarse input set (in the manner now familiar from the preceding discussion) by the PCD-resident driver software, communicating via the IMU and control bus 707 under the supervision of the bus management system 706, through control line 719. Note, however, that the amplifier subsystem 701 also contains a primary gain monitor unit 705, which accepts pre-filter 712, post-filter 721 and post-amplification 710 signals, and computes a continuous signal strength metric for each one. This system feeds its results 706 via the bus management unit (BMU) to the command bus 707, for the ultimate consumption of the PCD-resident drivers, but is also capable of operating in a direct feedback automatic gain control mode, in which the information computed is passed 711 to the primary gain controller 722, to allow rapid equalisation of the signal. Note that the amplifier 718 should exhibit extremely good linearity.

DOWN-CONVERTER

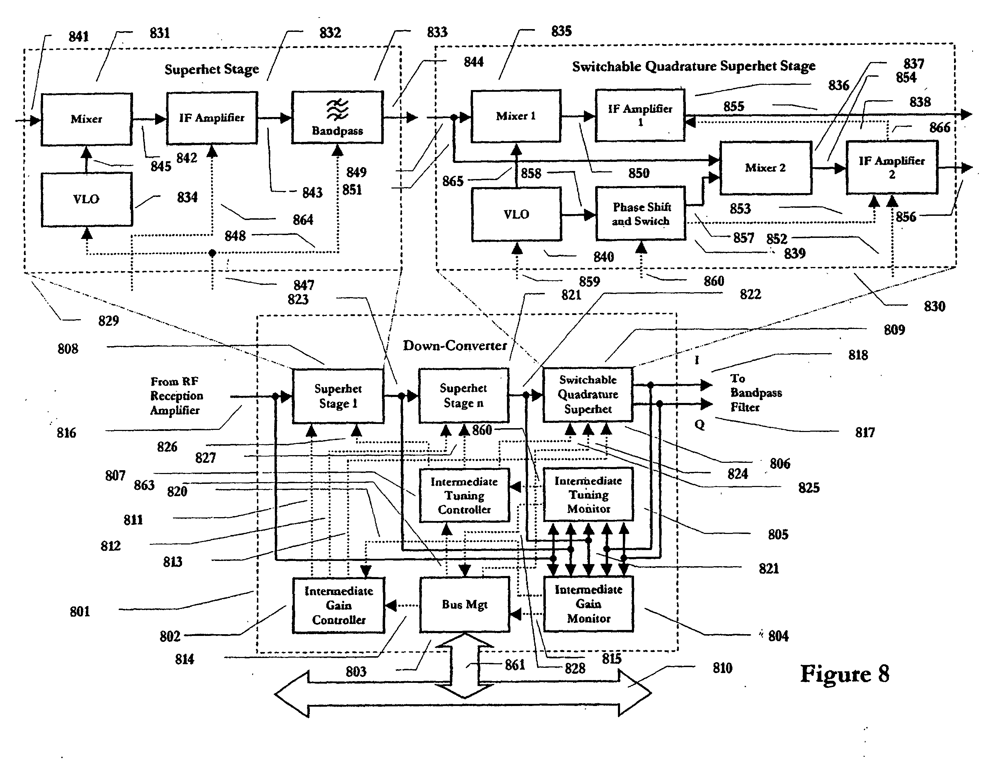

Having undergone amplification and selection within the RF reception amplifier 701, the RF signal is next passed 709 to the down-converter stage, corresponding to 105 in FIG. 1, and shown in detail in FIG. 8. The overall purpose of the down-converter stage 801 is to render an amplified version of the desired signal at a much lower nominal centre frequency (but with identical bandwidth) to the received signal. The goal is to bring the signal down to a frequency where it can sensibly be digitised and fed into the PCD in the subsequent stages of the system. Primary signal gain is also possible at the down-converter stage, aided by the fact that a known nominal centre frequency (at some point in the down-conversion chain) may be attained, easing amplifier design (particularly with regard to bandwidth / frequency response).

The incoming, amplified RF signal 816 is passed through a number of superheterodyne stages 808...821 which are responsible for shifting the signal to an appropriate IF point, providing filtering to remove unwanted components, and amplifying the signal to a useful level. In the preferred embodiment of the RF transceiver of the current invention, there are a total of four primary superhet stages (only two 808/821 are shown in the diagram, for clarity), followed by a quadrature superhet 809, although designs with fewer or greater number of frequency conversion stages are possible. Each superhet may be switched out of circuit if required, under control of the intermediate tuning controller 807, which receives input from the driver software on the PCD, via the IMU and the command bus 810. As before, a BMU 803 is responsible for managing the intercommunication 861 between the bus 810 and the local modules. It provides the feed 863 to the intermediate tuning controller. The controller in turn sends messages to each of the superhet stages via command lines 826/827/825.

In an alternative embodiment designed for maximum frequency agility, a two-dimensional matrix of superhet stages is provided, each of which may be switched in or out under the control of drivers running on the PCD. In this arrangement, specialised first and second stage superhets are used for the initial conversion of microwave, UHF and sub-UHF RF.

In another alternative embodiment, so-called 'direct conversion' of the RF signal is employed. Direct conversion involves down-conversion in a mixer using an injected LO signal at the nominal centre frequency. This process obviates the image frequency problem (and corresponding image rejection circuitry), but does introduce a DC component into the signal, because the IF is 'wrapped around' the 0Hz point. This DC component causes serious problems with regard to amplification (see, for example, Abidi, A., "Low-Power Radio Frequency ICs for Portable Communications", pp. 58-60, in Larson, L. (Ed.) RF and Microwave Circuit Design for Wireless Communications, 1996. Artech House Inc., Norwood, MA, USA.), rendering the technique unsuitable for a number of modulation schemes, such as analogue FM and certain multi-carrier systems. Direct conversion is however useful for such schemes as binary FSK (frequency shift keying).

A more detailed view of the functional components of one of the standard superhet stages is shown in 808. The incoming RF signal 841/816/823 is passed into a mixer 831, where it is combined with a frequency 845 from a variable local oscillator (VLO) 834. In a preferred embodiment, the VLO is implemented using digital synthesiser technology, to allow a wide frequency range, excellent accuracy, and rapid reconfiguration. However, other embodiments are clearly possible. In one such arrangement, the first stage of the down-conversion uses a synthesised VLO 834, the frequency of which may be selected by the feed 847/826/827 from the intermediate tuning controller 807, but subsequent stages use fixed frequency oscillators, to reduce cost and complexity. In another arrangement, a varactor diode system, rather than a digital frequency synthesiser, is used to generate the LO signal 845. In yet another arrangement, in which the capture rate of the analogue to digital converter (ADC) stage (107 in FIG. 1) is sufficiently high that the RF signal may directly be digitised, and it is not desired to perform analogue quadrature, the entire down-converter stage 801 may be omitted. Note also that, although the overall purpose of the down-convener 801 is to shift the acquired RF signal to an accessible IF (or to baseband, or even 0Hz IF, if appropriate), the reduction in nominal centre frequency need not be monotonic across the superhet stages. For example, it may be advantageous, for certain frequency ranges, actually to up-convert the signal in the early superhets, to assist in the reduction of image frequencies in the later stages.

The result of the mixer 831 is then passed 842 into an IF amplifier 832, which will increase the strength of the signal. In a preferred embodiment of the RF adaptor of the current invention, wideband IF amplifiers are used. However, it is also possible to provide a degree of selectivity by using tuned IF amplifiers. In one alternative embodiment of the system. the IF amplifiers 832/836/838 are tuneable under software control, ultimately via the feed 847/859/826/827/825 from the intermediate tuning controller 807. The gain of the IF amplifier stage is set by a feed 864/811/812/813 from the intermediate gain controller subsystem 802. As in the RF stages, taps 821 are taken off the signal as it progresses through the stage 801, and these feed both an intermediate gain monitor 804 and an intermediate tuning monitor 805. The gain monitor reports 815 overall metrics of signal strength gain to the drivers on the PCD via the BMU 803, control bus 810 and IMU. It also has a switchable feedback path 820 to the intermediate gain controller 802, which allows an automatic gain system (AGC) to be employed where desired, which is useful with constant-envelope modulation schemes, such as COFDM/QPSK or conventional FM. This system can be disabled for other, variable envelope schemes (such as AM), for which it may not be appropriate; alternatively, with a sufficiently long integration time for the signal metrics within the gain monitor unit 815, even some variable envelope schemes may enjoy the benefits of AGC.

The main feed 814 to the intermediate gain control is under the ultimate control of driver software in the PCD.

The intermediate tuning monitor 805 provides set of metrics indicating the degree of frequency lock that has been obtained, as computed from the set of input taps 821. In a preferred embodiment, this will involve at least the use of a set of phase-locked loops to generate phase error signals. These metrics are reported back to the PCD drivers via channel 828; however, a feedback path 860 is also provided to the intermediate tuning controller 807, to allow an automatic frequency control (AFC) system to be utilised when required. One use of this would be to shift the injection VLO frequencies in the superhets 808/821/809 to ensure that a 'lock' was maintained on a signal, where the nominal centre frequency of the signal was wandering' on the spectrum due to poor transmitter stability, and to compensate for any lack of accuracy or drift in the VLO 834/840 units themselves.

The amplified signal 843 will contain undesirable modulation components, which are then attenuated by the bandpass filter 833, after which the conversion sub-stage 808 is complete and the signal passes on 844/823/822 to the next sub-stage. In a preferred embodiment. the phase and frequency transfer function of the bandpass filter 833 are electronically controlled, by signals sent via a line 848 from the intermediate tuning controller 807.

The initial superhet stages 808... 821 are non-quadrature units, operating on signals only in the 'in-phase' or 'I' mode. The output of one stage is fed into the input of the next (e.g., 823 feeds into 821). However, in a preferred embodiment of the system, the final superhet stage 809 is able to operate in a quadrature mode (twin down-converters operating with VLO signals of identical frequency but $\Pi/2$ out of phase). 830 shows this subsystem in more detail. The inbound signal 849/822 is split into two. One signal is heterodyned in mixer 1 835 with the in phase 'I' signal 865 from the VLO 840 to produce the I output 850, which is then boosted in IF amplifier 1 836 to produce the I channel output 855/818. The other signal is heterodyned with a quadrature ('Q') LO signal, produced by passing the output 858 of VLO 840 through a switchable phase-shift network 839. The quadrature LO 857 is combined with the signal 851 in mixer 2 837, and the resulting Q channel 854 is then boosted in IF amplifier 2, 838 to produce the Q output 856/817. Note that the quadrature shift system may be switched off if desired (indeed, as with all of the superhet stages, the entire sub-unit may be circumvented if need be, through the use of bypass routing switches, not shown on the diagrams for clarity). If the system is switched off or bypassed, only the I output 855/818 will contain a valid signal for processing by the rest of the system.

As with the earlier superhet stages, and according to a preferred embodiment, the VLO 840 is provided by a frequency synthesiser under the management of the intermediate tuning controller 807 (and ultimately, driver software running on the PCD), though a line 859/825. The driver modules in the PCD also manage the phase shift network through feed 860/824, and there is a pass-through control 853 to IF amplifier 2 838, to allow it to be switched out when the IQ system is not required. The gain of this amplifier 838 is set by the intermediate gain controller through line 852/813, and there is a pass-through control 866 for the gain of amplifier 1 836 also provided.

The primary reason for the quadrature superhet system 809 is to provide for efficient FFT analysis of the signal when subsequently taken into the PCD

## ANTI-ALIASING BANDPASS FILTER

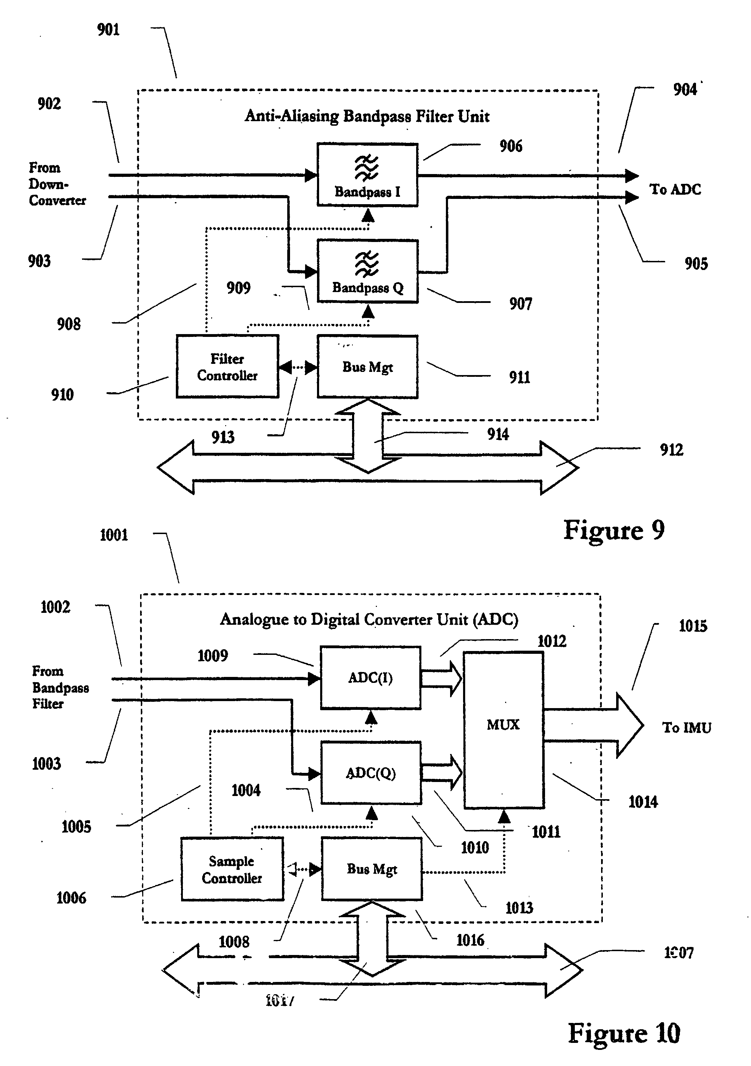

Having thus been down-converted to a workable frequency, the next stage is to pass the inbound signal 818/855 (or I/Q signals 818/855/817/856) to the anti-aliasing bandpass filter unit, corresponding to 106 in FIG. 1, and shown in detail in FIG. 9. The primary purpose of this system 901 is to ensure that the inbound signals (to ease description, it will be assumed from this point that both the I 902 and Q 903 signals are to be handled, although for certain operational modes only the 'I' signal 902 may be present, as discussed above) 902/903 are purged of frequencies that might cause aliasing within the subsequent analogue to digital converter (ADC) stage. Aliasing occurs when an ADC 'mistakes' a frequency above its safe acquisition rate for a lower frequency, causing an spurious reading. According to the Nyquist sampling theorem, an ADC must sample at twice the highest frequency contained in the signal; by the same token, the function of the anti-aliasing filter before the ADC must be to remove any signals that have a frequency higher than half that of the ADC sampling frequency. To this extent, it might appear that a simple lowpass filter at half the sampling rate would suffice for 901, but this is not the case for a number of reasons. Firstly, there may be lower-frequency components which are not needed in the signal, which will require the filter to be a bandpass, rather than a simple lowpass. Secondly, the roll-off of conventional (non-active) low-pass filters is poor, so placing a cut-off at half the sampling frequency is dangerous. Third, the sampling rate of the ADC in a system such as that described here must, for efficiency, be variable, and will be proportional to the bandwidth of the required signal. This will mean that the frequency and phase response curves of the filter will have to be modifiable.

For these reasons, the anti-aliasing filters in a preferred embodiment of the device are implemented as electronically variable active bandpass units, of high quality. Their parameters are set, ultimately under control of driver software running on the PCD, through the control bus 912. The BMU 911 interfaces 914 to the bus 912, and passes information to and from the filter controller 910. This unit is responsible for driving the actual filters 906/907 through control lines 908/909.

## ANALOGUE TO DIGITAL CONVERTER (ADC)

Having undergone bandpass filtering to remove undesirable components, the down-converted I/Q signal is next passed 904/905 to the analogue to digital converter (ADC) stage, corresponding to 107 in FIG. 1, and shown in detail in FIG. 10.

The overall purpose of the ADC unit 1001 is to render the down-converted I/Q signals 1002/1003 into digital form, in order that they might be submitted to the PCD for digital signal processing and demodulation (once again, it will be assumed for ease of description that both I 1002 and Q 1003 signals are to be acquired, although in some modes only the I 1002 signal will be of interest, in which case it alone will be acquired).

The signal conversion, from analogue to pulse-code modulated (PCM) digital data, is provided by two ADCs 1009/1010. In a preferred embodiment of the RF adaptor of the current invention, these ADCs are capable of sampling operation over a wide frequency range (up to around 50 million samples per second (MSPS), operate in 'flash' mode (have a constant conversion time across their legal input range), provide at least 16 bits of accuracy, and are monotonic with no missing codes and high transfer function linearity. Other embodiments are envisaged in which, to lower costs, simpler ADCs are used, such as 2MSPS 8 bit devices, or just one ADC operating on the I channel only (there being no quadrature superhet in the down-converter). Clearly, due to Nyquist, the rate of sampling must be at least twice that of the highest frequency allowed through by the bandpass filter unit (106 in FIG. 1), and preferably somewhat more for safety. This is ultimately determined by the widest bandwidth signal which the device is designed to acquire. The digitisation of a narrowband Mobitex signal, at 12.5kHz bandwidth, would be comfortably be captured (subject to suitable down-conversion to a nominal AF centre frequency of no more than 9.75 kHz) by a 32kSPS ADC. A wideband CDMA signal, however, would require much higher sampling rates. Clearly, there are a number of practical considerations for the speed and accuracy of the ADCs. The limits of existing analogue to digital technology, ultimate bus speed into the PCD, and processing speed of the PCD all place constraints upon the highest feasible sampling rate. However, it is expected that, following the historical trend, the capability of each of these factors will rise over time, at which time higher sampling rate ADC units may be incorporated within embodiments of the RF adaptor of the current invention. Another point to note is that, if the acquired signal is destined to be processed by a fast Fourier transform (FFT) within the PCD, then the sampling rate should be arranged such that, for a FFT window time which provides an orthogonal transform to the original carriers (if this is the modulation mechanism used), the number of samples taken is a power of 2. This makes the FFT operation more efficient.

The sampling rate vs, time function is controlled by the sample controller 1006, under the ultimate management of driver software running within the PCD. Commands are issued to the sample controller via the command bus 1007. BMU 1016 interfaces the bus 1017 to the sample controller 1006 via line 1008, and to the multiplexer 1014 (of which more in a moment) via line 1013. The sample controller implements the sampling clocks for the ADCs, and sets other parameters (such as 8/16 bit sampling mode, if appropriate) through the interface lines 1005/1004. The sampling clock is synthesised from a main high-frequency clock which is distributed through the bus 1007 on a shielded line; however, the sampling is effectively asynchronous with respect to the PCD clock. The sample controller also contains a real time clock counter (RTCC) to allow the generation of non-constant sampling functions. This is useful for a number of different applications. For example, in a TDMA (time division multiple access) scheme, the system will only be required to 'capture' information being passed on the inbound signals 1002/1003 within a particular cyclical time 'slot' - at other times the samplers can be shut off. The sampling frequency function in such a scenario would be a rectangular wave train. Similarly, multi-rate signals may be present on a single channel over time (for example, low bandwidth control signals followed by high bandwidth data signals). In this case, the sampling rate would be decreased and increased as required by the sample controller 1006, to ensure that at any given point in the signal where information of interest is carried, that the Nyquist criterion is met without excess sampling (which will only cause unnecessary load on the system, with little or no added benefit).

The digitised I 1012 and Q 1011 bussed parallel signals are next passed into a multiplexer (MUX) unit 1014. The purpose of this is to render them into a single parallel stream to ease subsequent processing. The MUX 1014 is controlled through line 1013, ultimately under the management of the drivers within the PCD. The main purpose of this control is to switch the MUX between pass-through mode (in which only the I 1012 channel contains any data, and is simply connected to output bus 1015), and interleave mode (in which both the I 1012 and Q 1011 channels contain data, and must be time-division multiplexed into the single bussed signal 1015). Note that bussing is used because, at the high sampling speeds required of the ADCs when broadband signals are involved, serial connectivity would be very inefficient. Also note that, with respect to the main system bus and microcontroller clock, the ADCs 1009/1010 and MUX 1014, and their respective busses 1012/1011/1015 are effectively running asynchronously.

INTERFACE MANAGEMENT UNIT (IMU)

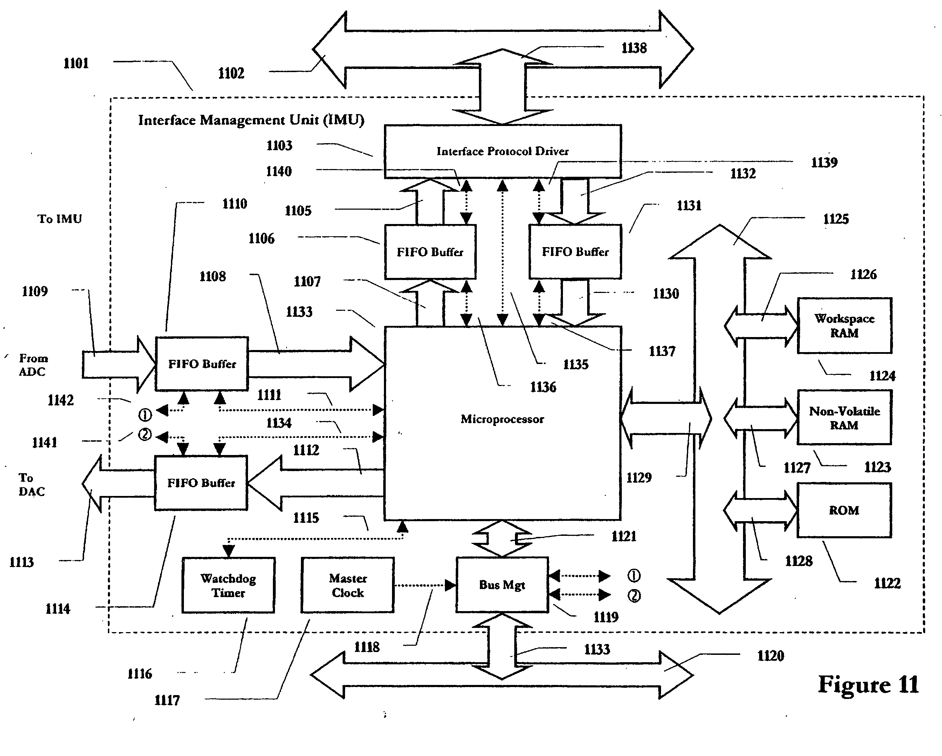

The bussed, multiplexed digital I/Q sample stream is then passed 1015 to the interface management unit (IMU) stage, corresponding to 108 in FIG. 1, and shown in detail in FIG. 11.

As its name suggests, the main purpose of the IMU is to manage the interface between the personal computing device (PCD, 109 in FIG. 1) on which the driver modules reside, and the rest of the system. The bussed inbound signal 1109 from the ADC unit (107 in FIG. 1) is passed into a first-in first-out (FIFO) buffer memory unit 1110, which allows the effectively asynchronous data capture to be interfaced to the microprocessor 1113 and passed to the host PCD. It also prevents data being lost if the microprocessor 1113 should be busy. The FIFOs 1110 and 1114 can be controlled from the outside (namely, from the ADC and DAC units, respectively, 107 and 110 in FIG. 1), via the control bus 1120. The bus management unit (BMU) 1118 controls the flow of information to and from 1133 the control bus 1120 and the various sub-stages of the IMU, including a bussed connection 1121 to the microprocessor 1133 and various control lines. One set of controls 1142 drives the input port management of FIFO 1110 under the ultimate control of the ADC stage (107 in FIG. 1); another drives the output port management of FIFO 1114 under the ultimate control of the DAC stage (110 in FIG. 1). The output port to inbound FIFO 1110 is controlled by the microprocessor 1113 via line 1111, which allows the microprocessor 1113 to read samples off the FIFO 'queue' via bus 1108.

The microprocessor 1113, on receipt of information from the ADC stage (107 in FIG. 1), is responsible for performing whatever preliminary processing (if any) is required (which, in the present invention, does not involve demodulation), and then passing the information on to the PCD where the main signal demodulation will take place. The microprocessor 1133 may insert timing information into the sample stream to assist the PCD routines if desired. On the reverse path, it is responsible for taking any modulated, digitised data from the PCD and passing it through bus 1112 to the input port of the outbound FIFO 1114, controlled via line 1134.

In the preferred embodiment of the RF adaptor of the current invention, little signal processing of any significance occurs within the microprocessor, most of this being left to the more powerful main processor (or processors) within the PCD itself. To clarify, in the preferred embodiment, no demodulation of the inbound signal or modulation of the outbound signal is provided by the IMU, these functions all being performed in software executing on the PCD. However, in the preferred embodiment, 'time slicing' of inbound signals is a function of the IMU. This is of use in time division multiplexed (TDM) systems, where the inbound signal is only of interest during certain periodic intervals. In such cases, the drivers on the PCD instruct the IMU to transfer data only during those relevant intervals, and to discard data at other times. This eases the burden of data transfer, while not detracting from the requirement that the PCD demodulate the digitised, 'sliced' signal that is passed through.

The microprocessor 1133 has a significant role to play in managing the overall behaviour of the various components of the transceiver system, under the ultimate control of the software drivers within the PCD. This is beneficial, as it allows that, during the short periods where the PCD is too busy to respond, the RF adaptor can still function correctly with respect to frequency hopping, output power attenuation, TDMA signalling and other behaviours which may be required by a particular transmission scheme in use, whether on the forward or back channel. It also provides a significant advantage from a regulatory point of view, since the microprocessor 1133 ultimately sets the legal frequency ranges and bandwidth parameters for the device, and so it can act as a reliable block on illegal transmissions and reception intercept attempts, even should the user attempt to circumvent these provisions by writing a 'rogue' driver for the PCD (or should a driver error occur). A cryptographic authentication must be passed from the driver to the microprocessor in order to allow the system to modify the spectral/power mask.

The microprocessor 1133 has access 1129 to a main memory bus 1125 to which three different types of randomly addressable memory unit are connected. The first is the workspace random access memory (RAM) 1124, which is connected via access bus 1126, and which is used to hold the running state of programs running on the microprocessor 1113. The second is the non-volatile RAM 1123, which is connected via access bus 1127, and which is used to hold configuration information that must not be lost upon power loss (such as for example, unit identity information, software patches, legal spectrum/power masks, counts of transmitted energy against time, and so on). The third 'is the read-only non-volatile memory (ROM) 1122, which is connected via access bus 1128, which is used to hold non-changing information within the system, such as core software routines. The microprocessor 1133 is protected from 'hanging' by watchdog timer 1116, which will cause a reset condition should the processor fail to update it at suitably frequent intervals via control line 1115. The master clock for the synchronous part of the processing arrangement 1117, which, in a preferred embodiment is generated by division of the PCD interface bus 1138 clock if one is available, is distributed on the control bus 1120 through line 1118, and is also distributed to all the main components of the IMU 1101.

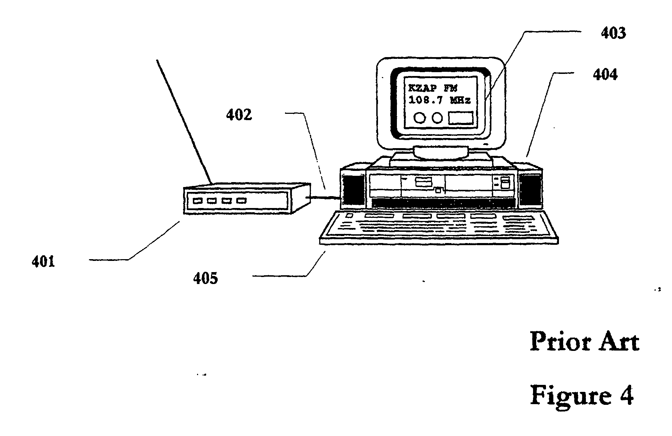

In normal operation, upon initialisation the drivers within the PCD may download software routines into the workspace RAM 1124 or non-volatile RAM 1123, to customise the operation of the device (although any tuning or power commands issued must fall within the legitimate power/spectrum mask, as mentioned above, or they will not be executed). It will easily be appreciated by those of ordinary skill in the art that an embodiment of the RF adaptor of the current invention is possible, in which some or all of the functions within the IMU 1101, and indeed some or all of the control bus 1120 and some or all of the functions of the associated 'controllers' (such as, for example, the rough tuning controller 704 in FIG. 4, and bus management units throughout the system), are replaced by a single microcontroller (or small number of microcontrollers), to reduce cost.

After any processing which may be required (as discussed above), inbound data is passed by the microprocessor 1133 to the input port of the FIFO buffer 1106 via bus 1107, with port control line 1136. This queue of received, digitised (and interleaved, in I/Q mode) samples is then read from the output port of the FIFO 1106 by interface protocol driver (IPD) 1103, via bus 1105, with port control line 1140. The IPD is responsible for dealing with the various control lines, voltage levels, handshaking and coding that are required by the particular PCD bus interface in use, under the control of the microprocessor 1133 via line 1135. For example, depending on the embodiment, IPD 1103 may implement any or all of: a small computer system interface (SCSI) interface driver, a PC memory card international association (PCMCIA) interface driver, a universal serial bus (USB) interface driver, a peripheral component interconnect (PCI) interface driver, an industry standard architecture (ISA) or extended industry standard architecture (EISA) interface driver, a RS423/232 interface driver, or a driver for any other high-speed interface with which modern PCD devices are now or come to be equipped. Clearly, the faster the interface the better, particularly if the system is to be used to acquire high-bandwidth signals. In such a case, the slower ports (such as the conventional serial RS423/232) will be entirely unsuitable unless only a small amount of signal is occasionally required, in which cse the adapter could buffer the signal prior to transfer. Furthermore, for best performance, the interface bus should be able to support the function of direct memory access (DMA), which allows data to be streamed into and from the memory of the PCD without the interaction of the main processor unit on the PCD. This type of arrangement has the advantage of producing much less load upon the PCD system. Indeed, in an alternative embodiment of the RF adaptor of the current invention, the input FIFO 1110 is able directly to pass information directly to the output FIFO 1106, and input FIFO 1131 is able to pass information directly to output FIFO 1114, to maximise throughput. In any case, the inbound information (together with clocking, interrupt and other control lines which may be read and/or written by the IPD 1103) are passed via connection 1138 to the main memory bus of the PCD.

Once the data has been passed to the PCD, it is stored within the main memory (or streamed to a secondary or tertiary storage device). Eventually, it is digitally processed using software to demodulate it and recover the originally transmitted information. The system of "plug-in" drivers that perform such operations will be discussed in more detail later in this desciption.

Next, however, consider the reverse path to that just considered, in which information is first modulated in software on the PCD to generate a stream of pulse-code modulated (PCM) digital samples which represent a low intermediate frequency (IF) (down to the a range from 0Hz to $f_{max}$ Hz in the limit, where $f_{max}$ represents the bandwidth of the synthesised signal - although it will be better if centred around a somewhat higher point than $f_{max}$ /2, to avoid DC blocking effects etc.)

In a preferred embodiment, the synthesised signal samples are placed by the PCD drivers into a section of memory within the PCD as they are generated, from where they are fetched using DMA by the IPD 1103 over the connection 1138 to the PCD's main memory bus 1102. In alternative embodiments, symmetric to those discussed for the input case previously, data is streamed by the IPD from where the PCD drivers have placed it, on a secondary or tertiary storage device, or is generated in 'full real time' and passed directly from the PCD's main processor (or processors) to the IMU 1101. In any case, the outbound data (which may contain cueing and other control information) is passed 1132 into the input port of FIFO 1131, managed by port control line 1139. The microprocessor 1133 reads samples from this queue via bus 1130, using control line 1137, performs any necessary (management) processing, and then passes these samples to the input port of FIFO 1114 via bus 1112, managed by port control line 1134. The data is then read 1113 from this FIFO's 1114 output port by the asynchronous digital to analogue converter (DAC) (110 in FIG. 1), with control line 1141 being connected through the main control bus 1120. Note that an alert condition will be signalled should the DAC require data from the FIFO 1114 in the situation that this FIFO is empty, since in this case a discontinuity will occur in the output signal. The microprocessor 1133 may be programmed to provide some form of emergency sample substitution in this case, such as a damped predictive decay projection. Note that the microprocessor 1133 is responsible for detecting control commands from the driver units (and interleaving in messages coming back to the drivers via the control bus 1120), and passing these messages on to the bus management unit 1119 which will then either direct them to the appropriate module locally within the IMU 1101 or pass the message via the control bus 1120.

DIGITAL TO ANALOGUE CONVERTER (DAC)

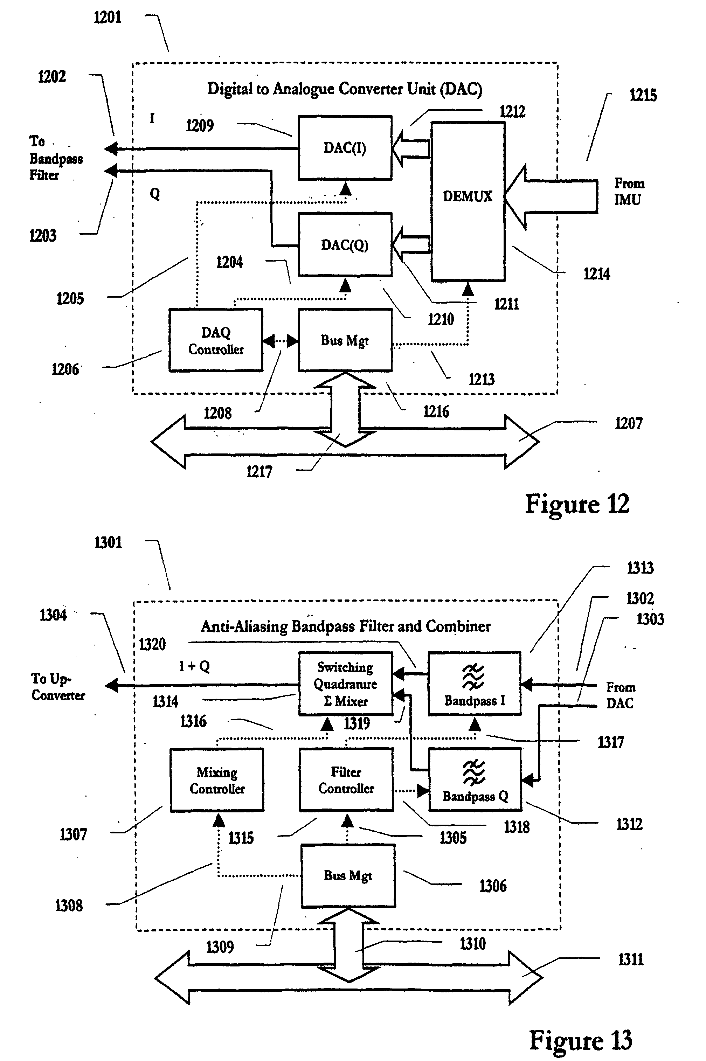

In the normal case, however, the bussed, multiplexed digital I/Q sample stream is passed 1113 to the digital to analogue converter (DAC) unit, corresponding to 110 in FIG. 1, and shown in detail in FIG. 12.

Within the DAC 1201, the outbound stream 1215 of interleaved, PCM I/Q samples is first passed into demultiplexer (DEMUX) 1214. This unit, which is controlled through line 1213, and is ultimately under the management of the software driver modules within the host PCD, extracts the in-phase ('I') 1212 and quadrature ('Q') 1211 data streams from the interleaved common stream 1215, Note, however, that as with input, there are two primary operating modes for output, and, in a second mode, only I signals are generated. In such a case the DEMUX 1214 operates in a pass-through mode, and only the I DAQ 1209 is used.

The primary purpose of the DAC stage 1201 is to convert the digital PCM sample stream into analogue signals which can then upconverted and transmitted. This process is performed in two high-speed DACs 1209 and 1210. It will be assumed for ease of description in the following that both I 1212 and Q 1211 signals are to be generated, although in some modes only the I signal 1212 will be of interest, and the other Q DAC 1210 will be switched out of circuit.

In a preferred embodiment of the RF adaptor of the present invention, these DACs 1209/1210 are capable of generating signals based on input over a wide frequency range, from just above DC to around 50MSPS, with fixed-lag conversion, high (at least 16 bit) accuracy, and are monotonic with no missing codes and high transfer function linearity. However, other embodiments are also possible, in which, to lower costs, simpler ADCs are used, such as 2MSPS 8 bit devices, or a single ADC operating on the I channel stream only (with the removal of the quadrature channel from the outbound phase of the design entirely, removing the additive mixer (1314 in FIG. 13) also).

As with the inbound channels, the outbound data rate has to be provided at twice the rate of the highest frequency to be generated in the analogue I 1202 and Q 1203 signals (due to the Nyquist sampling theorem). and preferably somewhat higher to account for the finite roll-off of real-world bandpass filters. This synthesising rate will be set under control of the driver software modules in the PCD, depending on the bandwidth of the signal being synthesised. Commands to set the conversion rate are passed through the control bus 1207, and are accepted by the bus management unit (BMU) 1216 through connection 1217. They are then directed to the DAQ controller 1206 via control line 1208. The DAQ controller 1206, under said instruction, implements the sample generation clocks for the DACs, and sets other parameters (such as 8/16 bit resolution, for example) through the interface lines 1205/1204. As for the ADC stage (107 in FIG. 1), the sample generation clock is synthesised from a main high-frequency clock which is distributed through the bus 1207 on a shielded line. Generation of samples is essentially asynchronous with respect to the PCD clock - indeed, one of the main functions of the feeder FIFO (1114 in FIG. 11) is to match the synchronous clock IMU system (108 in FIG. 1) with the (relatively) asynchronous DAC system 1201.

The DAQ controller 1206 contains a real time clock counter (RTCC) to allow the generation of non-constant sample-generation functions. This is useful, for example, with TDMA (time division multiple access), in which the system is only allowed to transmit data within a particular cyclical time 'slot'. With such a system the DACs 1209/1210 can be shut off at other times, to conserve power, and the sample generation function in such a case would be a rectangular wave train. A similar argument would hold for the generation of variable-bandwidth signals.

ANTI-ALIASING BANDPASS FILTER AND COMBINER

When the PCM sample stream is converted into analogue electrical waveforms (either just the I signal 1202 or I - Q 1202/1203), the next stage is to pass these signals to the anti-aliasing bandpass filter and combiner unit (AABFCU), corresponding to 111 in FIG. 1, and shown in detail in FIG. 13.

The overall purpose of the AABFCU is to remove the high frequency noise that is generated by the digital to analogue conversion process just discussed. The outbound signals 1302/1303 will contain unwanted harmonics due to the quantized nature of the DAC process, and which exist above the Nyquist point of half the sample generation frequency. These signals must not be allowed to reach the up-converter, or they will produce many modulation products and possibly generate interference that will be transmitted by the antenna.

The most straightforward remedy might seem to be to apply a simple lowpass filter to each of the I 1302 and Q 1303 signals, but this is not the case for a number of reasons. Firstly, there may be a 'sampling floor' on the signal, which may have been synthesised at a nominal centre frequency that is higher than half the bandwidth. In this case, any signal components with a frequency lower than that of the synthesised signal must be suppressed, which will require the filter to be bandpass, rather than simple lowpass. Secondly, since the roll-off of conventional (non-active) filters is poor, placing a cut-off at half the sampling frequency is not sufficient. Third, since the DAC sample generation rate in the sort of system herein described must, for efficiency, be variable, in proportion to the bandwidth of the synthesised signal, the frequency and phase response curves of the filter will have to be dynamically modifiable, which is not possible with a simple passive filter.

For these reasons, the anti-aliasing filters in a preferred embodiment of the RF adaptor of the current invention are implemented as electronically variable active bandpass units, of high quality. Their parameters are set, ultimately under control of driver software running on the PCD, through the control bus 1311. The bus management unit (BMU) 1306 interfaces 1310 to the bus 1311, and passes information to and from the filter controller 1315 via line 1305 and the mixing controller 1307 via line 1308 The filter controller 1315 then uses interface lines 1317/1318 to control the operation of the bandpass filters 1313/1312.

The bandpass filtered I/Q signals 1320/1319 are next passed into an additive mixer unit 1314. The operation of this unit is managed by the mixing controller 1307, under ultimate management of the driver units running on the PCD. The purpose of the mixer 1314 is to combine the I and Q signals in an additive manner to produce a single composite I+Q signal 1304. Note that when the system is operating in 'I-only' mode, the mixer is switched out by the mixing controller 1307, so that the output signal 1304 becomes a straight passthrough of the filtered 'I' signal 1320.

The method of operation of the mixer 1314 will commonly involve heterodyning with an LO signal and that LO signal shifted $\Pi/2$ out of phase. The details of this system are not shown here for clarity, since quadrature will be much less frequently used on the synthesis path than the analysis path ( details of I and Q reconstruction systems may be found in Haykin, S., Communication Systems (3rd edition), pp.85-89, John Wiley & Sons, Inc. New York, NY, USA).

Of course, it should be appreciated that the 'I only' mode will have the I and Q components combined together in digital form, and produced as a real ('I') sample stream - there is nothing 'missing' from the signal. A similar analysis can be performed for the 'I only' mode of the inbound signal.

UP-CONVERTER

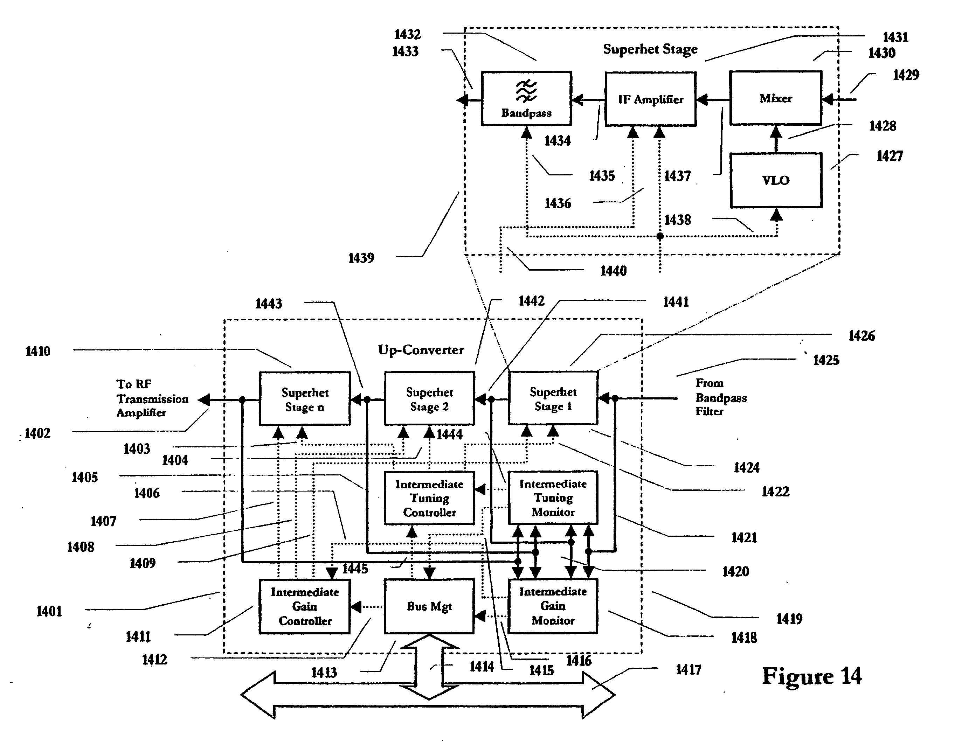

In any case, the I or I-Q analogue signal 1304 to the up-converter stage, corresponding to 112 in FIG. 1, and shown in detail in FIG. 14. The overall purpose of the up-converter stage 1401 is to render an amplified version of the desired signal at the target transmission nominal centre frequency, which will in general be much higher than the nominal centre frequency at which the signal was synthesised (that will normally be at, or just above, half the required signal bandwidth).

Primary signal gain is also possible at the up-converter stage, aided by the fact that a known nominal centre frequency (at some point in the up-conversion chain) is attained, easing amplifier design (particularly with regard to the bandwidth / nominal original central frequency response).

The incoming, IF signal 1425/1429 is passed through a number of superheterodyne stages 1424.. 1442.. 1410 which are responsible for shifting the said signal to the appropriate RF nominal centre frequency ready for transmission, providing filtering to remove any unwanted components, and amplifying the signal to a useful level prior to the final RF transmission amplifier stage (113 in FIG. 1). In the preferred embodiment of the RF transceiver of the current invention, there are a total of three primary superhet stages, although designs with fewer or greater number of frequency conversion stages are possible. In an alternative embodiment, a number of frequency multiplication units are utilised within the up-converter 1401. For certain types of signals, up conversion may best be achieved by a switched combination of frequency multipliers and superhets, rather than by superhets alone. However, frequency multipliers do have the disadvantage that the frequency deviation of the signal is multiplied when the nominal centre frequency is multiplied - which can mean, in effect, a reduction in the effective precision of the original digital synthesis.

Each superhet may be switched out of circuit entirely if desired, under control of the intermediate tuning controller 1405, which receives input from the driver software on the host PCD, via the IMU and the command bus 1417. A bus management unit (BMU) 1413 is responsible for managing the intercommunication 1414 between the bus 1417 and the local modules. It provides the feed 1445 to the intermediate tuning controller 1405. This controller in turn sends messages to each of the superhet stages via command lines 1403/1404/1422.

1439 shows a more detailed view of the functional components of one of the superhet stages. The incoming IF signal 1429/1425/1441/1443 is passed into a mixer 1430, where it is combined with a frequency 1428 from a variable local oscillator (VLO) 1427. In a preferred embodiment, the VLO 1427 is implemented using digital synthesiser technology, to allow a wide frequency range together with excellent accuracy and rapid reconfiguration. The said frequency may be selected by the feed 1438/1422/1403/1404 from the intermediate tuning controller 1405, under the ultimate control of software drivers running in the PCD. However, other embodiments of the oscillator system are possible. In one such arrangement, the first and third stage converters 1424/1410 use synthesised VLOs, while the intermediate superhet 1442 uses a fixed IF and a fixed frequency oscillator, to reduce cost and complexity. In such an arrangement, the second, fixed stage would provide most of the substantive amplification to the signal, since there the amplifier performance can most easily be optimised to a known, fixed IF. In another alternative embodiment, single stage up-conversion is used, and in yet another, where the device is intended to broadcast at or below a maximum frequency $f_{syn}/2$, where $f_{syn}$ is the highest sample rate which can be used on the DAC stage (110 in FIG. 1), the entire up-converter stage is omitted, and the system may be used in direct digital synthesis (DDS) mode. The use of frequency multipliers within the up-converter is also possible and has been discussed above.

The result of the mixer 1430 is then passed 1437 into an IF amplifier 1431, which will increase the strength of the signal. In a preferred embodiment of the system, the IF amplifier 1431 is tuneable under software control, ultimately via the feed 1436/1422/1403/1404 from the intermediate tuning controller 1405. The gain of the IF amplifier stage 1431 is set by a feed 1440/1409/1408/1407 from the intermediate gain controller subsystem 1411. As in the down-converter (105 in FIG. 1), taps 1420 are taken off the signal as it progresses through the stage 1401. and these feed both an intermediate gain monitor 1418 and an intermediate tuning monitor 1421. The gain monitor 1418 reports 1416 overall metrics of signal strength gain to the drivers on the PCD via the bus management unit (BMU) 1413, the control bus 1417 and the IMU (108 in FIG. 1). A switchable feedback path 1406 to the intermediate gain controller 1411 is also provided, in order that an automatic gain control for the output signal can be employed where necessary. In most modes of operation, this system will not be required, as the various filter and amplifier transfer functions and signal strengths will be known to the PCD-resident drivers, which can set equalisation levels appropriately through direct commands sent to the intermediate gain controller 1411. However, it does provide a useful 'fail safe' ability to shut off the transmission path rapidly, should a software or firmware error 'upstream' in the transmission chain cause too large a signal to be generated.

The intermediate tuning monitor 1421 provides a set of metrics indicating the degree to which the desired intermediate 'step-up' frequencies have been attained, as computed from the signals provided by the input taps 1420. In a preferred embodiment of the system, this will involve at least phase-locked loops used to generate a set of phase error signals. These metrics are reported back to the PCD drivers via channel 1415; however, a feedback path 1444 is also provided to allow an automatic frequency control (AFC) system to be utilised where desired. One use of this would be to shift the injection VLO frequencies in the superhets 1426/1442/1410 to ensure that a 'lock' was maintained on the appropriate up-conversion frequencies, thereby compensating for any tendency of the VLO units 1427 to drift.

The resultant signal 1434 is next subjected to the bandpass filter 1432, in order that undesirable modulation components can be removed. After this process, the conversion sub-stage 1439 is complete and the signal passes on 1433/1441/1443/1402 to the next sub-stage. In a preferred embodiment, the phase and frequency transfer functions of the bandpass filter 1432 are electronically controlled, by signals sent via a line 1435/1403/1404/1422 from the intermediate tuning controller.

RF TRANSMISSION AMPLIFIER

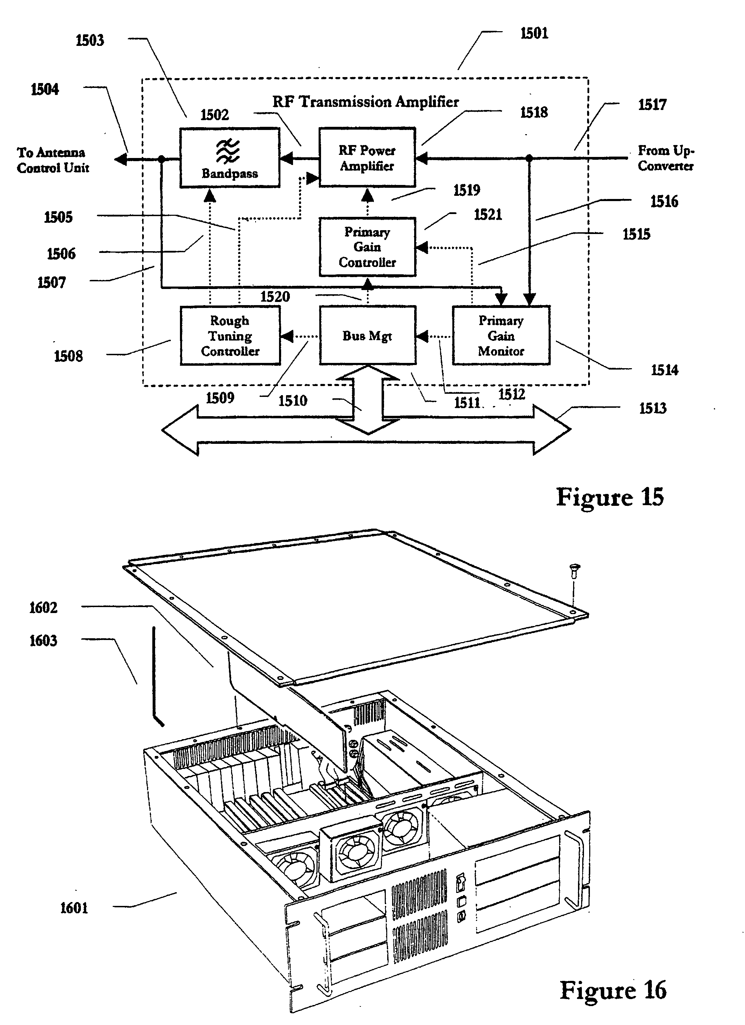

Having thus been up-converted to the transmission frequency, the outbound signal 1402 is next passed into the RF transmission amplifier unit, corresponding to 113 in FIG. 1, and shown in greater detail in FIG. 15. The primary purpose of this system is to increase the power of the transmitted signal to a level suitable for transmission through an antenna (or antennae).

The main component here is an RF power amplifier 1518, which accepts the signal 1517 and increases it in power, producing the signal 1502. In a preferred embodiment of the RF adaptor of the current invention, the power gain of the amplifier is variable under the supervision of the primary gain controller 1521, fed through control line 1519. This gain is ultimately managed by the software driver modules within the PCD, which send instructions via the command bus 1513. The bus management unit (BMU) 1511 interfaces 1510 to this bus, and passes messages between it and components within the stage. In this way, commands arrive at the primary gain controller through line 1520.

In a preferred embodiment, the RF amplifier exhibits a degree of tuned response, which can be electronically managed by the rough tuning controller 1508, via interface line 1505. As with the primary gain controller, instructions are sent to this system from the driver modules in the host PCD, via command bus 1513 and line 1509.

The amplified signal 1502 is next subjected to a bandpass filter 1503, to suppress undesirable harmonics within the signal. In a preferred embodiment, this filter unit 1503 has electronically selectable frequency and phase transfer functions, under the management of the rough tuning controller 1508 (and ultimately, the PCD-resident drivers) through interface line 1506.

The overall power output of this stage is continually measured by the primary gain monitor 1514, through taps from the output 1507 and pre-amplification signal 1516. This information is fed back to the PCD drivers via the control bus 1513 on line 1512. However, a direct feedback path is also provided 1515 to the primary gain controller 1521, in order that an automatic power gain control of the output signal may be provided, if desired.

The power-amplified, filtered outbound signal 1504 is then passed (through line 617 in FIG. 6) to the antenna control unit (103 in FIG. 1) where it is matched to one or a number of antenna, subjected to final filtering, and transmitted. The operation of the antenna control unit has already been discussed.

FORM FACTORS

The RF adaptor of the current invention may be embodied in a number of different form factors. FIG. 16 shows an embodiment of the device which is fitted as an internal card 1602 to an IBM PC or compatible computer 1601. A small external antenna 1603 is provided, although the user could connect other external antenna systems if desired. In this mode, the system may be provided as an ISA, EISA, PCI or other internal card format that is now, or may come to be, known in the computer interfacing art. An advantage of the internal card format is the ability to access the main memory of the PCD at high speed, usually with DMA abilities; which in turn allows efficient operation of the system even with high bandwidth signals and even when the main processor (or processors) is temporarily busy.

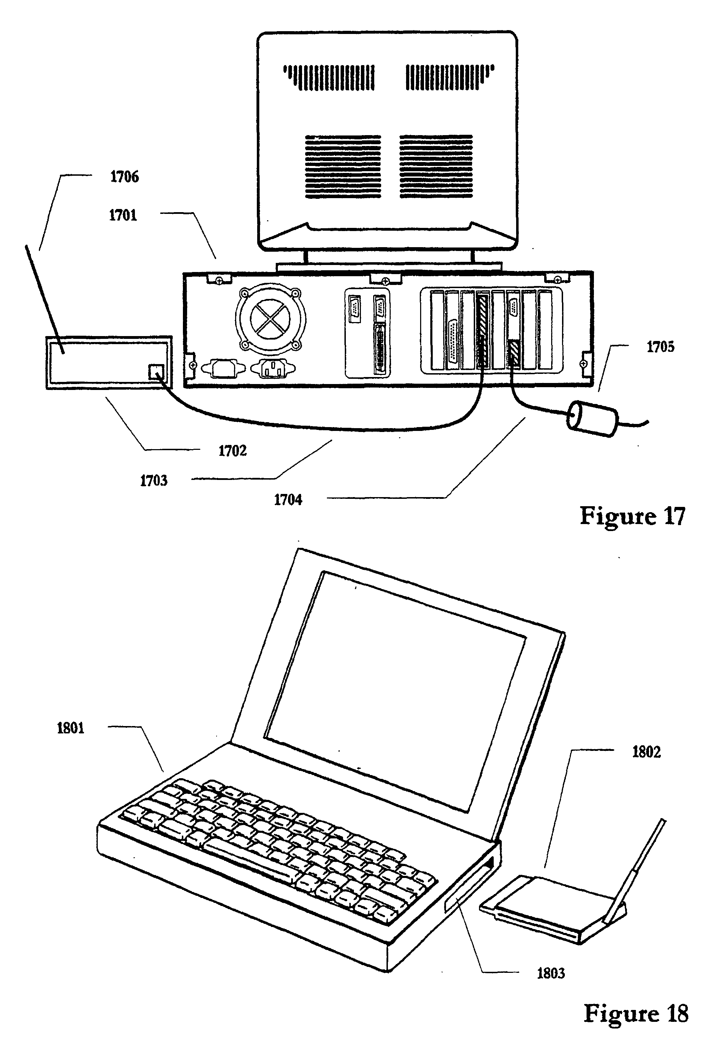

For optimal RF shielding, the transceiver adaptor may be embodied in an external housing such as that shown in FIG. 17, 1702. Here, the connection to the PCD 1701 is made via a high speed parallel interface, such as a SCSI connection 1703. Connection to the printer port of IBM-compatible PCs is also possible, for medium-bandwidth signals; however, this will not suffice for wide bandwidth transmissions, such as DAB. The transceiver device may be provided with an integral antenna 1706. although the user may connect additional, higher performance antennae if required.

It is also envisaged that the entire system could be produced as one (or a very small number) of dedicated integrated circuits, which would then allow for an extremely compact embodiment. 1705 shows an example of such a system, where the 'bulge" contains the integrated transceiver electronics, and the antenna for the system is provided within the connection cable 1704 by which the device is connected to the PCD. In this particular example, a USB (universal serial bus) connection is shown, although for low bandwidth signals, a conventional RS232/423 serial port could be used (as indeed, could some form of parallel interface).

It is further envisaged that the transceiver device could be embodied within a PCMCIA (now called simply PC) card format, as shown in FIG. 18. The card 1802 contains an integrated antenna, and fits into an industry-standard slot 1803 in the PCD. The PC card format is advantageous in that it provides for high data transfer rates, and is an interface implemented across a large number of PCDs, including laptop PCs (such as that shown 1801) and PDAs.

SOFTWARE DRIVER STRUCTURE

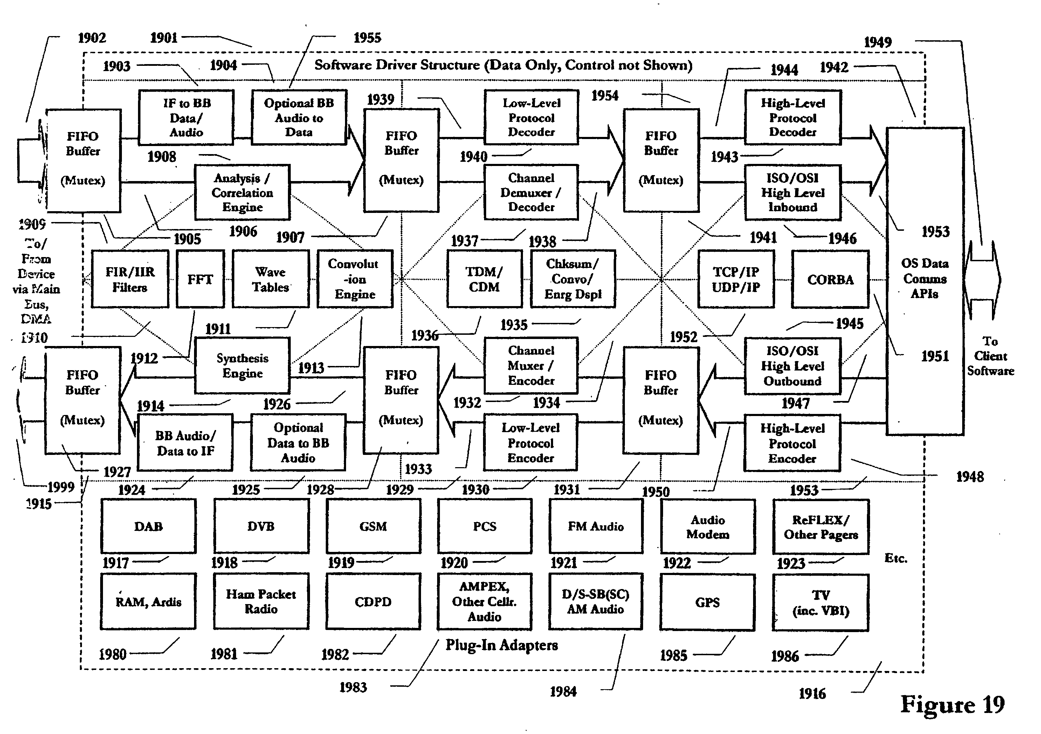

An architecture for the software driver modules within the PCD, according to a preferred embodiment of the RF transceiver system of the current invention, is shown in FIG. 19. Inbound data (passed to the software 1902 by the interface management unit (IMU), 108 in FIG. 1), is read 1906 from a first-in first-out (FIFO) structure 1905. This may be implemented either in the main memory of the PCD, or as a stream onto a file in a secondary or tertiary store connected to the PCD. In any case, the FIFO 1905 is protected by a mutual exclusion lock (mutex) to prevent the IMU attempting to write data into a given location while the driver modules are attempting to read it, thereby causing a undesirable race condition.

In a preferred embodiment of the software drivers 1901, a separate thread of execution is active for each subsection of the driver system. The first subsection 1904 has the task of acquiring the modulating digital signal from the inbound digitised sample stream 1906; this corresponds to the physical layer of the ISO/OSI model (described earlier). Routine 1903. parameterised by the particular plug-in scheme in use for inbound information 1916. acquires the primary digital bitstream, drawing as necessary upon a common library of routines, containing implementations of techniques well known to those in the digital signal processing art. These include an analysis and correlation engine 1908, which may be employed to compute a degree of match between a reference and target waveform, a set of finite impulse response (FIR) and infinite impulse response (IIR) digital filters 1909, to allow the shaping and selective frequency processing of samples, a fast Fourier transform and synthesis engine 1912, to allow PCM data, recorded as amplitude samples in the time domain. to decomposed into the frequency domain, a set of wave tables 1911, which may be used as the reference for correlation by engine 1908, and a convolution engine 1913. Having been thus analysed, the bitstream may, if it is in a suitable format, be further processed by an audio decomposition software engine 1955, which fulfils the function of the AF demodulator 525 in FIG. 5. For certain data protocols, it may be necessary for the stream to be protocol decoded, before the audio information can be retrieved (in which case this module will be re-entered).

In the general case, however, the baseband bitstream is acquired in module 1904, and it is then injected into memory mutexed FIFO 1907 From here, the data stream is picked up 1939 (in the preferred embodiment of the system) by a thread running the next module 1938, which has responsibility to process the low-level data protocols (this corresponds to the link and network layers from the ISO/OSI model). The thread runs the main low-level protocol decoder routine 1940, which can make use of a library of common functions, including a channel demultiplexer and decoder 1937, a time division multiplexing (TDM) code division multiplexing (CDM) decoder 1936 (which may be parameterised by the plug-in modules 1916 detailing the particular scheme in use), and a set of routines 1935 to perform common functions. The latter includes the ability to perform various types of checksum, including cyclic redundancy checks (CRCs, which may be compiled down into a lookup table for efficiency in the case of simple polynomials), a generic convolutional decoder, capable of dealing with punctured codes, and based on the algorithm due to Viterbi, and an energy dispersal recovery system, which provides the ability to regenerate information which has been 'exclusive-or'-d with a pseudo-random bitstream prior to transmission. In an alternative embodiment of the system, this module will also deal with various conditional access mechanisms, such as cryptographic scrambling, which may have been applied to the bitstream prior to transmission.

Once the data has passed through the low-level protocols, it is injected into memory mutexed FIFO 1941 as a set of objects, representing the basic low-level transport units. These objects are extracted 1944 by a thread running in the next module 1954, which is responsible for dealing with high level protocols, including those protocols which have been encapsulated or 'tunnelled' through the radio transport medium. The thread runs a main routine 1943, which is particularised by the selected plug-in from the set 1916, and which deals with the transport to the presentation layers of the ISO/OSI model. It can draw on a library of common routines, including a generic protocol stack manager 1946, a TCP/IP and UDP/IP transport layer 1952, and a high-level CORBA object request broker (ORB) 1951. The result of this layer is a set of high-level objects (which may include events) which are placed into a final buffer 1942, from where they are picked up and distributed 1949 through the data communications application programming interfaces (APIs) to interested client software and into the system event stream. This process need not be polled; the API can allow incoming requests to trigger interrupts forcing 'callbacks' to occur to the client code.

Turning now to the return path, the client software issues objects and events 1949 which are to be conveyed to a remote site across the radio link. These are processed by the operating system (OS) communications APIs and are placed into a mutexed buffer 1942, from where they are retrieved 1950 by the thread responsible for the high-level protocol processing module 1953. This thread executes the generic high-level protocol routine 1948, which is parameterised by the particular 'plug-in' module 1916 currently in use. The encoder may make use of the software modules 1952 and 1951 already mentioned, and also a generic outbound high-level protocol stack 1945. The output of this module is a set of low-level objects representing messages to be conveyed across the wireless link, represented in a common format no matter what the higher level protocol. These objects are deposited in the memory mutexed FIFO 1931.

From this point, the objects are picked up 1933 by the thread executing the next module 1929, responsible for providing the low-level encoding. This thread executes the generic low-level protocol routine 1930, which is parameterised by the plug-in module currently in use 1916, and can make use of a generic library of routines, including those already mentioned 1936/1935, in addition to a control system for channel multiplexing and encoding 1932. The result of this level (symmetric with the inbound flow) is a set of bit blocks which are enclosed in routing objects with limited ordering linkages. These objects are placed into the memory mutexed FIFO 1928.

Finally, these objects are processed by the thread in the physical layer encoder module 1915. This thread executes at least one of two routines, responsible for (optionally) translating the digital bitstream 1926 into an audio PCM representation 1925, and translating the final bitstream (be it audio or original input) into the encoded samples stream 1924. As with the input processing, these routines are parameterised by the particular (outbound, in this case) plug-in coding system in use 1916, and can draw on a library of useful routines - 1909, 1912, 1911 and 1913 have already been mentioned, and these are added to by a generic synthesis engine 1914, capable of constructing and then rendering into PCM (and other commands) the various transmission equations.

The resulting interleaved set of commands and data (possibly in I/Q format, depending on the transmission mode) is finally passed into the mutexed FIFO 1927, which may be implemented either in main memory, or as a stream onto secondary or tertiary storage connected to the device (for pre-computed feeds). From this point, the RF adaptor (102 in FIG. 1) can read 1999 the information, being made aware of the newly produced content by interrupt if necessary.

The flexibility of the system lies in the fact that it may be customised to different transmission protocols (both for inbound and outbound use) by the addition of plug-in driver modules, which act through a common API. These modules are able to accept and generate control-bus (126 in FIG. 1) messages to the transceiver adaptor (102 in FIG. 1) and are also able to accept and receive data. controlling the operation of the generic modules discussed above.

There is potentially no limit to the number of different modulation/demodulation schemes that may be implemented by such a system, other than that imposed by the available processing resources and memory of a given user's system. However, at least the following plug-in modules are provided in a preferred embodiment of the system a transcoder for the Digital Audio Broadcasting (DAB) protocol 1917, a transcoder for the Digital Video Broadcasting (DVB) protocols 1918, a transcoder for the GSM telecommunications system 1919 (including at least access to the short message service), a transcoder for the at least some of the modulation schemes used within the range of PCS telecommunications systems 1920, a transcoder for conventional FM audio broadcasts 1921, a transcoder for standard PC-based audio modems (V34 et al) 1922, a transcoder for various two- and one- way paging protocols, including at least ReFLEX, FLEX and InFLEXion 1923, a transcoder for conventional data networks including RAM and Ardis 1980, a transcoder for amateur band (HAM) packet radio 1981, a transcoder for cellular digital packet data (CDPD) 1982, a transcoder for conventional cellular audio. including digital variants and AMPEX) 1983, a transcoder for the various forms of single and double sideband AM audio 1984, a transcoder for at least the civilian forms of GPS (Global Positioning System) 1985, and a transcoder for the various formats of television broadcasting 1986, which will include the ability to acquire digital information stored within the vertical blanking interval (VBI). Of course, these only give an example of the protocols that can be acquired and synthesised - a chief advantage of the invention being the ease with which, using familiar coding tools and paradigms on IBM-compatible PCs, or other PCDs, new or as yet unimplemented protocols and standards can be incorporated, without replacement of the hardware. Of course, the ability (described above) of the RF adaptor of the current invention to receive and transmit signals of various bandwidths across a wide range of the spectrum is central to such flexibility.

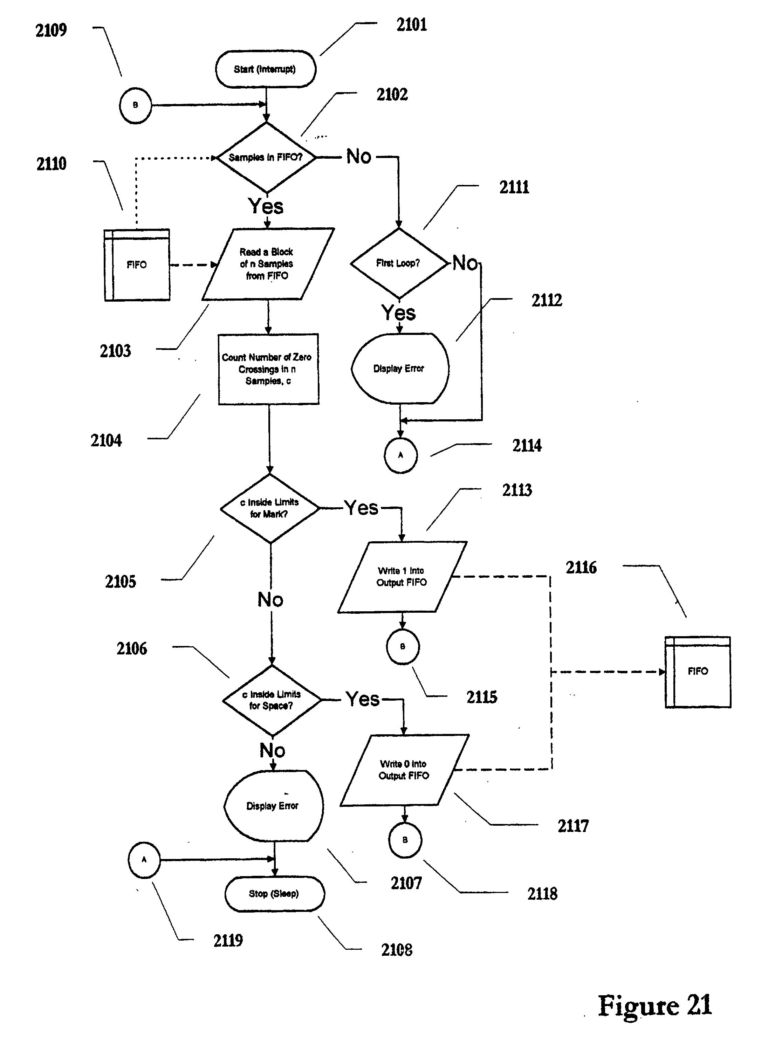

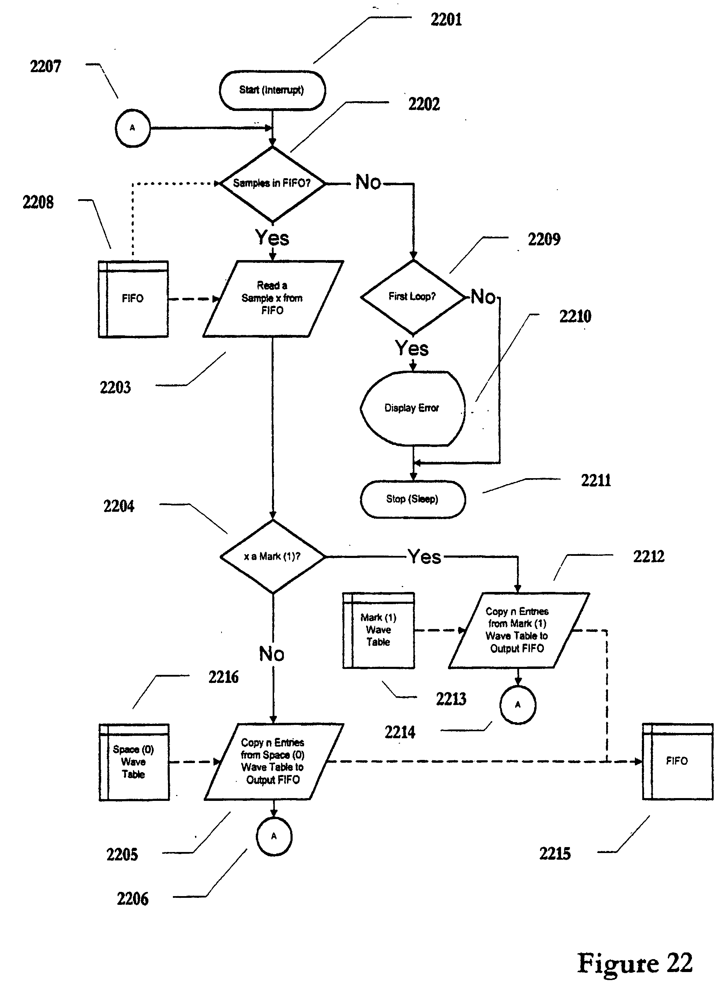

As an example of the process of software demodulation and modulation, consider FIGS. 21 and 22, which are flow charts describing the physical layer demodulation and modulation (respectively) of a simple binary frequency shift keying (BFSK) scheme.

Turning first to FIG. 21, the physical layer thread activates 2101 when an interrupt indicates that data is or should be waiting in the inbound FIFO 2110 (corresponding to 1905 in FIG. 19). The routine checks to see if data is indeed present 2102, and if not, then tests if this is the first time around the loop since the interrupt occurred 2111. If it is, then an error is generated 2112 and the thread goes back into a waiting state 2114/2119/2108. If not, then the thread simply goes into the waiting state, assuming that all available data has been consumed 2114/2119/2108.

In the normal case, however, data is available and the thread reads a block of n PCM samples 2103 from the FIFO 2110. These n samples are assumed to have been captured in 'I-only' mode, to cover the period of one encoded bit in the signal, and to be synchronised to bit boundaries by such clock recovery methods as are well known in the art (this mechanism is not shown for clarity). The number of zero crossings in this pulse train is then counted 2104, using a threshold limiting method to avoid noise effects with small-amplitude samples. (FIG. 21 shows, of course, a very elementary BFSK demodulator for clarity; other methods of demodulation for BFSK are known in the art.) This count is then compared with an upper and lower limit for a 'mark' or binary 1 2105. If this test is failed, a check is made to see if the count falls with the 'space' or binary 0 limits 2106. If this is also failed, an error is displayed 2107 and the thread goes back into a sleep mode 2108. In all such error cases, the system FIFOs may be flushed if desired.

If, however, a mark is detected, a binary ' 1' is written 2113 into the FIFO 2116 (corresponding to the buffer 1907 in FIG. 19) for consideration by the higher levels of demodulation, which are not shown here for clarity. Similarly, if a space is detected, a binary '0' is written 2117 into the FIFO 2116. In both cases, the loop is then restarted to process the next n samples 2115/2109,2118/2109.

FIG. 22 shows the process for transmission. The physical layer thread activates 2201 when an interrupt indicates that data is or should be waiting in the inbound (relative to the modulator) FIFO 2208 (corresponding to 1928 in FIG. 19). The routine checks to see if data is indeed present 2202, and if not, then tests if this is the first time around the loop since the interrupt occurred 2209. If it is, then an error is generated 2210 and the thread goes back into a waiting state 2211. If not, then the thread simply goes into the waiting state, assuming that all available data has been consumed 2211.

In the normal case, however, data is available and the thread reads 2203 a single bit x from the FIFO 2208, into which data has been placed by higher levels of modulation and encoding within the driver structure. This bit x is checked to see if it is a 'mark' (1) 2204, and if it is, then the thread copies a vector of n samples 2212 from a wave table 2213 (which holds pre-computed PCM samples of a carrier modulated to the 'mark' frequency offset, at a predetermined sample rate, for one bit period) into the output (relative to the modulator) FIFO 2215 (corresponding to 1927 in FIG 19). If x is not a mark (1), then it must be a 'space' (0), and in this case the thread copies a vector of n samples 2205 from a wave table 2216 (which holds pre-computed PCM samples of a carrier modulated to the 'space' frequency offset, at a predetermined sample rate, for one bit period) into the output FIFO 2215. In both cases, the loop is then restarted 2214/2207,2206/2207 to process the next bit. (FIG. 22 shows, of course, a very elementary BFSK modulator for clarity; other methods of modulation for BFSK are known in the art.)

These and other aforementioned demodulation and modulation schemes are only an example of the protocols that can be acquired and synthesised - a chief advantage of the invention being the ease with which, using familiar coding tools and paradigms on IBM-compatible PCs, or other PCDs, new or as yet unimplemented protocols and standards can be incorporated, without replacement of the hardware.

**Claims**

1. Communications apparatus comprising means (104) for receiving a modulated radio frequency signal at least one means (105) for down-converting the received modulated radio-frequency signal to an intermediate frequency, means (107) for digitising the down-converted signal and means (108) for exporting at least a part of the digitised modulated signal to a personal computing device(109) in which the personal computer comprises a main processor programmed to perform demodulation of the digitised modulated signal.

2. Communications apparatus as claimed in claim 1, wherein the means (108/1101) for exporting at least a part of the digitised modulated signal comprises means for connection (1138) to at least one bus (114) within the personal computing device.

3. Communications apparatus as claimed in claim 2, wherein the means (108/1101) for exporting at least a part of the digitised modulated signal further comprises means (1103) for performing direct memory access with memory means located within the personal computing device.

4. Communications apparatus as claimed in claim 1, wherein the means for exporting at least a part of the digitised modulated signal comprises means (1133) for dividing the signal with respect to time.

5. Communications apparatus as claimed in claim 1, wherein the means (105/801) for down-converting a received modulated radio-frequency signal comprises means for generating an in-phase down converted signal (818/855) and a quadrature phase down-converted signal (817/856), and the means (107/1001) for digitising a down-converted signal comprises means for digitising the in-phase down converted signal (1012) and the quadrature phase down-converted signal (1011).

6. Communications apparatus as claimed in claim 1, wherein the means (105/801) for down-converting a received modulated radio-frequency signal comprises means for generating a single down-converted signal (818/855).

7. Communications apparatus as claimed in claim 6, wherein the means (105/801) for down-converting a received modulated radio-frequency signal are arranged to convert the frequency of the received modulated radio signal by less than the centre frequency of the signal minus half of the bandwidth of the signal.

8. Communications apparatus as claimed in claim 1, further comprising means (1133) for altering the bandwidth of the received modulated radio-frequency signal

9. Communications apparatus as claimed in claim 1, further comprising means (808) for altering the centre frequency of the received modulated radio-frequency signal.

10. Communications apparatus as claimed in claim 9, wherein the means (808) for altering the centre frequency of the received modulated radio-frequency signal comprise means for frequency-hopping.

11. Communications apparatus as claimed in claim 1, further comprising means (832) for altering the amplitude of the down converted received modulated radio-frequency signal.

12. Communications apparatus as claimed in claim 8, wherein the means for altering parameters (1133) further comprise means for responding to at least one command (912) from a personal computing device.

13. Communications apparatus as claimed in claim 12, wherein the means for altering parameters further comprises means for comparing that at least one command with at least one predetermined permitted parameter and means responsive only to commands possesing permitted parameters.

14. Communications apparatus as claimed in claim 13, further comprising means for altering the at least one permitted parameter in response to an encoded command from a personal computing device (109).

15. Communications apparatus as claimed in claim 1, wherein the apparatus is adapted for installation within a personal computing device (109).

16. Communications apparatus as claimed in claim 1, further comprising a personal computing device (109), the personal computing device comprising processing means and memory means which processing means are responsive to instructions stored in the memory means to demodulate the exported signal.

17. Communications apparatus as claimed in claim 1, further comprising means (114) for importing a digital modulated signal from a personal computing device, means (110) for converting the digital modulated signal to an analogue signal, means (112) for up-converting the analogue signal to a radio frequency signal and means (101) for transmitting the radio frequency signal.

18. Communications apparatus comprising (a) means (114) for importing a digital modulated signal from a personal computing device (109), modulation to generate the digital modulated signal at an intermediate frequency having been performed by a main processor in the personal computing device, (b) means (110) for converting the digital modulated signal to an analogue signal, (c) means (112) for up-converting the analogue signal to a radio frequency signal and (d) means (101) for transmitting the radio frequency signal.

19. Communications apparatus as claimed in claim 18, wherein the means (108/1101) for importing at least a part of the digital modulated signal comprises means (1138) for connection to at least one bus (114) within the personal computing device.

20. Communications apparatus as claimed in claim 19, wherein the means (108/1101) for importing at least a part of the digital modulated signal further comprises means (1103) for performing direct memory access with memory means located within the personal computing device.

21. Communications apparatus as claimed in claim 18, wherein the means for importing at least a part of the digital modulated signal comprises means (1133) for assembling the signal with respect to time.

22. Communications apparatus as claimed in claim 18, wherein the means (110) for converting the digital modulated signal to an analogue signal comprises means (1425) for converting an in-phase signal and a quadrature phase signal.

23. Communications apparatus as claimed in claim 22, wherein the means (112) for up-converting the analogue signal to a radio frequency signal comprises means responsive to an in-phase signal and a quadrature phase signal.

24. Communications apparatus as claimed in claim 18, wherein the means (112) for up-converting the analogue signal to a radio frequency signal comprises means responsive to a single analogue signal.

25. Communications apparatus as claimed in claim 24, wherein the means (112) for up-converting the analogue signal to a radio frequency signal are arranged to alter the frequency of the analogue signal by less than a required transmission centre frequency of the signal minus half of the bandwidth of the signal.

26. Communications apparatus as claimed in claim 18, further comprising means (111/1133) for controlling the bandwidth of the transmitted signal.

27. Communications apparatus as claimed in claim 18, further comprising means (112) for altering the centre frequency of the transmitted signal

28. Communications apparatus as claimed in claim 27, wherein the means for altering the centre frequency of the transmitted signal comprises means for frequency-hopping.

29. Communications apparatus as claimed in claim 18, further comprising means (113) for altering the amplitude of the transmitted signal.

30. Communications apparatus as claimed in claim 26, wherein the means (1133) for altering parameters further comprise means for receiving at least one command from a personal computing device (109), means for comparing that at least one command with at least one predetermined permitted parameter and means responsive only to commands possesing permitted parameters.

31. Communications apparatus as claimed in claim 30, further comprising means (1133) for altering the at least one permitted parameter in response to an encoded command from a personal computing device.

32. Communications apparatus as claimed in claim 18, wherein the apparatus is adapted for installation within a personal computing device (109).

33. Communications apparatus as claimed in claim 18, further comprising a personal computing device (109), the personal computing device comprising processing means and memory means which processing means are responsive to instructions stored in the memory means to demodulate the exported signal.

**Patentansprüche**

1. Kommunikationsvorrichtung, umfassend (ein) Mittel (104) zum Empfangen eines modulierten Radiofrequenzsignals, wenigstens ein Mittel (105) zum Abwärtsmischen des empfangenen modulierten Radiofrequenzsignals auf eine Zwischenfrequenz, (ein) Mittel (107) zum Digitalisieren des abwärtsgemischten Signals und (ein) Mittel (108) zum Exportieren wenigstens eines Teils des digitalisierten modulierten Signals zu einem persönlichen Rechnergerät (109), wobei der Personalcomputer einen Hauptprozessor umfasst, der zum Durchführen der Demodulation des digitalisierten modulierten Signals programmiert ist.

2. Kommunikationsvorrichtung nach Anspruch 1, bei der das Mittel (108/1101) zum Exportieren von wenigstens einem Teil des digitalisierten modulierten Signals ein Mittel zum Anschließen (1138) an wenigstens einen Bus (114) in dem persönlichen Rechnergerät umfasst.

3. Kommunikationsvorrichtung nach Anspruch 2, bei der das Mittel (108/1101) zum Exportieren von wenigstens einem Teil des digitalisierten modulierten Signals ferner ein Mittel (1103) zum Durchführen von Direktspeicherzugriff mit in dem persönlichen Rechnergerät befindlichem Speicher umfasst.

4. Kommunikationsvorrichtung nach Anspruch 1, bei der das Mittel zum Exportieren von wenigstens einem Teil des digitalisierten modulierten Signals ein Mittel (1133) zum Teilen des Signals in Bezug auf Zeit umfasst.

5. Kommunikationsvorrichtung nach Anspruch 1, bei der das Mittel (105/801) zum Abwärtsmischen eines empfangenen modulierten Radiofrequenzsignals Mittel zum Erzeugen eines gleichphasigen abwärtsgemischten Signals (818/855) und eines gegenphasigen abwärtsgemischten Signals (817/856) umfasst und das Mittel (107/1001) zum Digitalisieren eines abwärtsgemischten Signals Mittel zum Digitalisieren des gleichphasigen abwärtsgemischten Signals (1012) und des gegenphasigen abwärtsgemischten Signals (1011) umfasst.

6. Kommunikationsvorrichtung nach Anspruch 1, bei der das Mittel (105/801) zum Abwärtsmischen eines empfangenen modulierten Radiofrequenzsignals Mittel zum Erzeugen eines einzelnen abwärtsgemischten Signals (818/855) umfasst.

7. Kommunikationsvorrichtung nach Anspruch 6, bei der die Mittel (105/801) zum Abwärtsmischen eines empfangenen modulierten Radiofrequenzsignals zum Umsetzen der Frequenz des empfangenen modulierten Signals um weniger als die Mittenfrequenz des Signals minus der Hälfte der Bandbreite des Signals angeordnet sind.

8. Kommunikationsvorrichtung nach Anspruch 1, ferner umfassend Mittel (1133) zum Ändern der Bandbreite des empfangenen modulierten Radiofrequenzsignals.

9. Kommunikationsvorrichtung nach Anspruch 1, ferner umfassend Mittel (808) zum Ändern der Mittenfrequenz des empfangenen modulierten Radiofrequenzsignals.

10. Kommunikationsvorrichtung nach Anspruch 6, bei der die Mittel (808) zum Ändern der Mittenfrequenz des empfangenen modulierten Radiofrequenzsignals Mittel zum Frequenzspringen haben.

11. Kommunikationsvorrichtung nach Anspruch 1, ferner umfassend Mittel (832) zum Ändern der Amplitude des abwärtsgemischten empfangenen modulierten Radiofrequenzsignals.

12. Kommunikationsvorrichtung nach Anspruch 8, bei der die Mittel zum Ändern von Parametern (1133) ferner Mittel zum Reagieren auf wenigstens einen Befehl (912) von einem persönlichen Rechengerät haben.

13. Kommunikationsvorrichtung nach Anspruch 12, bei der das Mittel zum Ändern von Parametern ferner Mittel zum Vergleichen des wenigstens einen Befehls mit wenigstens einem vorbestimmten zulässigen Parameter und Mittel umfasst, die nur auf zulässige Parameter besitzende Befehle reagieren.

14. Kommunikationsvorrichtung nach Anspruch 13, ferner umfassend Mittel zum Ändern des wenigstens einen zulässigen Parameters in Reaktion auf einen codierten Befehl von einem persönlichen Rechengerät (109).

15. Kommunikationsvorrichtung nach Anspruch 1, bei der die Vorrichtung zur Installation in einem persönlichen Rechengerät (109) ausgeführt ist.

16. Kommunikationsvorrichtung nach Anspruch 1, ferner umfassend ein persönliches Rechengerät (109), wobei das persönliche Rechengerät einen Prozessor und einen Speicher hat, wobei der Prozessor auf in dem Speicher gespeicherte Anweisungen zum Demodulieren des exportierten Signals reagiert.

17. Kommunikationsvorrichtung nach Anspruch 1, ferner umfassend Mittel (114) zum Importieren eines digitalen modulierten Signals von einem persönlichen Rechengerät, Mittel (110) zum Umsetzen des digitalen modulierten Signals in ein analoges Signal, Mittel (112) zum Aufwärtsmischen des Analogsignals auf ein Radiofrequenzsignal und Mittel (101) zum Senden des Radiofrequenzsignals.

18. Kommunikationsvorrichtung, umfassend (a) Mittel (114) zum Importieren eines digitalen modulierten Signals von einem persönlichen Rechengerät (109), wobei Modulation zum Erzeugen des digitalen modulierten Signals auf einer Zwischenfrequenz von einem Hauptprozessor in dem persönlichen Rechengerät durchgeführt wurde, (b) Mittel (110) zum Umsetzen des digitalen modulierten Signals in ein analoges Signal, (c) Mittel (112) zum Aufwärtsmischen des analogen Signals auf ein Radiofrequenzsignal und (d) Mittel (101) zum Senden des Radiofrequenzsignal.

19. Kommunikationsvorrichtung nach Anspruch 18, bei der das Mittel (108/1101) zum Importieren wenigstens eines Teils des digitalen modulierten Signals Mittel (1138) zum Anschließen an wenigstens einen Bus (114) in dem persönlichen Rechengerät hat.

20. Kommunikationsvorrichtung nach Anspruch 19, bei der das Mittel (108/1101) zum Importieren wenigstens eines Teils des digitalen modulierten Signals ferner Mittel (1103) zum Durchführen von Direktspeicherzugriff mit einem in dem persönlichen Rechengerät befindlichen Speicher umfasst.

21. Kommunikationsvorrichtung nach Anspruch 18, bei der das Mittel zum Importieren wenigstens eines Teils des digitalen modulierten Signals Mittel (1133) zum Zusammensetzen des Signals mit Bezug auf Zeit hat.

22. Kommunikationsvorrichtung nach Anspruch 18, bei der das Mittel (110) zum Umsetzen des digitalen modulierten Signals in ein analoges Signal Mittel (1425) zum Umsetzen eines gleichphasigen Signals und eines gegenphasigen Signals umfasst.

23. Kommunikationsvorrichtung nach Anspruch 22, bei der das Mittel (112) zum Aufwärtsmischen des analogen Signals auf ein Radiofrequenzsignal (ein) auf ein gleichphasiges Signal und ein gegenphasiges Signal reagierende (s) Mittel umfasst.

24. Kommunikationsvorrichtung nach Anspruch 18, bei der das Mittel (112) zum Aufwärtsmischen des analogen Signals auf ein Radiofrequenzsignal (ein) auf ein einzelnes analoges Signal reagierende(s) Mittel umfasst.

25. Kommunikationsvorrichtung nach Anspruch 24, bei der die Mittel (112) zum Aufwärtsmischen des analogen Signals auf ein Radiofrequenzsignal die Aufgabe haben, die Frequenz des analogen Signals um weniger als eine erforderliche Sendemittenfrequenz des Signals minus der Hälfte der Bandbreite des Signals zu ändern.

26. Kommunikationsvorrichtung nach Anspruch 18, ferner umfassend Mittel (111/1133) zum Steuern der Bandbreite des gesendeten Signals.

27. Kommunikationsvorrichtung nach Anspruch 18, ferner umfassend Mittel (112) zum Ändern der Mittenfrequenz des gesendeten Signals.

28. Kommunikationsvorrichtung nach Anspruch 27, bei der das Mittel zum Ändern der Mittenfrequenz des gesendeten Signals Mittel zum Frequenzspringen hat.

29. Kommunikationsvorrichtung nach Anspruch 18, ferner umfassend Mittel (113) zum Ändern der Amplitude des gesendeten Signals.

30. Kommunikationsvorrichtung nach Anspruch 26, bei der die Mittel (1133) zum Ändern von Parametern ferner Mittel zum Empfangen von wenigstens einem Befehl von einem persönlichen Rechengerät (109), Mittel zum Vergleichen des wenigstens einen Befehls mit wenigstens einem vorbestimmten zulässigen Parameter und Mittel umfasst, die nur auf zulässige Parameter besitzende Befehle reagieren.

31. Kommunikationsvorrichtung nach Anspruch 30, ferner umfassend Mittel (1133) zum Ändern des wenigstens einen zulässigen Parameters in Reaktion auf einen codierten Befehl von einem persönlichen Rechengerät.

32. Kommunikationsvorrichtung nach Anspruch 18, bei der die Vorrichtung zur Installation in einem persönlichen Rechengerät (109) ausgeführt ist.

33. Kommunikationsvorrichtung nach Anspruch 18, ferner umfassend ein persönliches Rechengerät (109), wobei das persönliche Rechengerät Verarbeitungsmittel und Speicher umfasst, wobei die Verarbeitungsmittel auf in dem Speicher gespeicherte Anweisungen zum Demodulieren des exportierten Signals reagieren.

**Revendications**

1. Appareil de communication comprenant un moyen (104) récepteur d'un signal radiofréquence modulé au moins un moyen (105) démultiplicateur du signal radiofréquence modulé reçu en une fréquence intermédiaire, un moyen (107) de numérisation du signal démultiplié et un moyen (108) d'exportation d'au moins une partie du signal modulé numérisé vers un dispositif de calcul personnel (109) où l'ordinateur personnel comprend un processeur principal programmé pour effectuer la démodulation du signal modulé numérisé.

2. Appareil de communication selon la revendication 1, où le moyen (108/1101) d'exportation d'au moins une partie du signal modulé numérisé comprend un moyen de connexion (1138) avec au moins une barre omnibus (114) dans le dispositif de calcul personnel.

3. Appareil de communication selon la revendication 2, où le moyen (108/1101) d'exportation d'au moins une partie du signal modulé numérisé comprend en outre un moyen (1103) d'exécution d'un accès mémoire direct, le moyen de mémorisation étant situé dans le dispositif de calcul personnel.

4. Appareil de communication selon la revendication 1, où le moyen d'exportation d'au moins une partie du signal modulé numérisé comprend un moyen (1133) de division du signal en fonction du temps.

5. Appareil de communication selon la revendication 1, où le moyen (105/801) de démultiplication d'un signal radiofréquence modulé reçu comprend un moyen générateur d'un signal démultiplié en phase (818/855) et un signal démultiplié déphasé en quadrature (817/856), et le moyen (107/1001) de numérisation du signal démultiplié comprend un moyen de numérisation du signal démultiplié en phase (1012) et du signal démultiplié déphasé en quadrature (1011).

6. 'Appareil de communication selon la revendication 1, où le moyen (105/801) de démultiplication d'un signal radiofréquence modulé reçu comprend un moyen générateur d'un signal démultiplié seul (818/855).

7. Appareil de communication selon la revendication 6, où les moyens (105/801) de démultiplication d'un signal radiofréquence modulé reçu sont agencés de sorte à convertir la fréquence du signal radio modulé reçu selon une valeur inférieure à la fréquence nominale du signal défalquée de la moitié de la largeur de bande du signal.

8. Appareil de communication selon la revendication 1, comprenant en outre un moyen (1133) destiné à modifier la largeur de bande du signal radiofréquence modulé reçu.

9. Appareil de communication selon la revendication 1, comprenant en outre un moyen (808) destiné à modifier la fréquence nominale du signal radiofréquence modulé reçu.

10. Appareil de communication selon la revendication 9, où le moyen (808) destiné à modifier la fréquence nominale du signal radiofréquence modulé reçu comporte un moyen de saut de fréquences.

11. Appareil de communication selon la revendication 1, comprenant en outre un moyen (832) destiné à modifier l'amplitude du signal radiofréquence modulé démultiplié reçu.

12. Appareil de communication selon la revendication 8, où le moyen de modification des paramètres (1133) comprend en outre un moyen de réaction à au moins une commande (912) provenant d'un dispositif de calcul personnel.

13. Appareil de communication selon la revendication 12, où le moyen de modification des paramètres comprend en outre un moyen de comparaison d'au moins la commande susmentionnée avec au moins un paramètre prédéterminé autorisé et un moyen réagissant uniquement aux commandes présentant les paramètres autorisés.

14. Appareil de communication selon la revendication 13, comprenant en outre un moyen destiné à modifier au moins le seul paramètre autorisé en réponse à une commande codée provenant d'un dispositif de calcul personnel (109).

15. Appareil de communication selon la revendication 1, où l'appareil est adapté pour une installation dans un dispositif de calcul personnel (109).

16. Appareil de communication selon la revendication 1, comprenant en outre un dispositif de calcul personnel (109), ce dispositif de calcul personnel comprenant des moyens processeurs et un moyen de mémoire, les dits moyens processeurs réagissant aux instructions mémorisées dans le moyen de mémoire dans le but de démoduler le signal exporté.

17. Appareil de communication selon la revendication 1, comprenant en outre un moyen (114) destiné à importer un signal modulé numérique provenant d'un dispositif de calcul personnel, un moyen (110) destiné à convertir le signal modulé numérique en un signal analogique, un moyen (112) destiné à multiplier le signal analogique en un signal radiofréquence et un moyen (101) destiné à transmettre le signal radiofréquence.

18. Appareil de communication comprenant (a) un moyen (114) destiné à importer un signal modulé numérique provenant d'un dispositif de calcul personnel (109), la modulation devant générer le signal modulé numérique à une fréquence intermédiaire ayant été exécutée par un processeur principal dans le dispositif de calcul personnel, (b) un moyen (110) destiné à convertir le signal modulé numérique en un signal analogique, (c) un moyen (112) destiné à multiplier le signal analogique en un signal radiofréquence et (d) un moyen (101) destiné à transmettre le signal radiofréquence.

19. Appareil de communication selon la revendication 18, où le moyen (108/1101) devant importer au moins une partie du signal modulé numérique comporte un moyen (1138) de connexion sur au moins une barre omnibus (114) dans le dispositif de calcul personnel.

20. Appareil de communication selon la revendication 19, où le moyen (108/1101) devant importer au moins une partie du signal modulé numérique comporte en outre un moyen (1103) destiné à permettre un accès mémoire direct sur le moyen de mémoire situé dans le dispositif de calcul personnel.

21. Appareil de communication selon la revendication 18, où le moyen devant importer au moins une partie du, signal modulé numérique comporte un moyen (1133) destiné à assembler le signal en fonction du temps.

22. Appareil de communication selon la revendication 18, où le moyen (110) destiné à convertir le signal modulé numérique en un signal analogique comporte un moyen (1425) devant convertir un signal en phase et un signal déphasé en quadrature.

23. Appareil de communication selon la revendication 22, où le moyen (112) de multiplication du signal analogique en un signal radiofréquence comprend un moyen réagissant à un signal en phase et un signal déphasé en quadrature.

24. Appareil de communication selon la revendication 18, où le moyen (112) de multiplication du signal analogique en un signal radiofréquence comprend un moyen réagissant à un seul signal analogique.

25. Appareil de communication selon la revendication 24, où le moyen (112) de multiplication du signal analogique en un signal radiofréquence est agencé de sorte à modifier la fréquence du signal analogique selon une valeur inférieure à une fréquence nominale de transmission requise du signal défalquée de la moitié de la largeur de bande de ce signal.

26. Appareil de communication selon la revendication 18, comprenant en outre des moyens (111/1133) destinés à contrôler la largeur de bande du signal transmis.

27. Appareil de communication selon la revendication 18, comprenant en outre un moyen (112) destiné à modifier la fréquence nominale du signal transmis.

28. Appareil de communication selon la revendication 27, où le moyen destiné à modifier la fréquence nominale du signal transmis comporte un moyen de saut de fréquences.

29. Appareil de communication selon la revendication 18, comprenant en outre un moyen (113) destiné à modifier l'amplitude du signal transmis.

30. Appareil de communication selon la revendication 26, où le moyen (1133) destiné à modifier les paramètres comprend en outre un moyen récepteur d'au moins une commande provenant d'un dispositif de calcul personnel (109), un moyen destiné à comparer cette commande unique à au moins un paramètre prédéterminé autorisé et un moyen réagissant uniquement aux commandes présentant des paramètres autorisés.

31. Appareil de communication selon la revendication 30, comprenant en outre un moyen (1133) destiné à modifier le seul paramètre autorisé au moins en réaction à une commande codée provenant d'un dispositif de calcul personnel.

32. Appareil de communication selon la revendication 18, où l'appareil est adapté pour être installé dans un dispositif de calcul personnel (109).

33. Appareil de communication selon la revendication 18, comprenant en outre un dispositif de calcul personnel (109), ce dispositif de calcul personnel comprenant des moyens processeurs et un moyen de mémorisation, les dits moyens processeurs pouvant réagir aux instructions mémorisées dans le moyen de mémoire afin de démoduler le signal exporté.

Figure 1

Prior Art

Figure 2

EP 1 016 209 B1

Prior Art

Figure 3

**402**

**403**

**404**

**KZAP FM**
**108.7 MHz**

**401**

**405**

## Prior Art

## Figure 4

Figure 5

Figure 6

Figure 7

Figure 8

Figure 9

Figure 10

36

**Figure 11**

Interface Management Unit (IMU)

1101, 1102, 1138, 1103, Interface Protocol Driver, 1139, 1140, 1132, 1131, 1125

1110, 1105, 1106, FIFO Buffer, FIFO Buffer, 1126, Workspace RAM, 1124

To IMU

1108, 1107, 1133, 1130, 1137, 1123

1109, From ADC, FIFO Buffer, 1111, Microprocessor, 1135, 1136

1142, ①, 1134, ②, Non-Volatile RAM, 1127

1141

To DAC, FIFO Buffer, 1112, 1129, 1122, ROM, 1128

1113, 1115, 1121

1114, Watchdog Timer, Master Clock, Bus Mgt, ①, ②, 1119

1116, 1117, 1118, 1133, 1120

EP 1 016 209 B1

37

## Figure 12

Digital to Analogue Converter Unit (DAC)

1201
1202
To Bandpass Filter
I — 1209
Q
1203
1204
1205
1206

DAC(I)
DAC(Q)
DEMUX
From IMU

1212
1215
1211
1214
1213
1210

DAQ Controller
Bus Mgt

1208
1216
1207
1217

**Figure 12**

## Figure 13

Anti-Aliasing Bandpass Filter and Combiner

1301
1304
To Up-Converter
1320
I + Q
1314

Switching Quadrature Σ Mixer
Bandpass I
From DAC

1313
1302
1303
1317

1316
1319

Mixing Controller
Filter Controller
Bandpass Q

1307
1308
1315
1305
1318
1312

Bus Mgt
1306

1309
1310
1311

**Figure 13**

Figure 14

1503

1501

1504

1502

RF Transmission Amplifier

1518

1517

To Antenna
Control Unit

Bandpass

RF Power
Amplifier

From Up-
Converter

1505

1519

1521

1516

1506

Primary
Gain
Controller

1515

1507

1520

1508

Rough
Tuning
Controller

Bus Mgt

Primary
Gain
Monitor

1514

1509

1510

1511

1512

1513

## Figure 15

1602

1603

1601

## Figure 16

1706

1701

1705

1702

1703

1704

**Figure 17**

1801

1802

1803

**Figure 18**

Figure 19

Figure 20

2109

2101

Start (Interrupt)

B

2102

Samples in FIFO? — No

Yes

2110

FIFO

Read a Block of n Samples from FIFO

2103

2111

First Loop? — No

Yes

2112

Display Error

Count Number of Zero Crossings in n Samples, c

2104

2114

A

c Inside Limits for Mark? — Yes

2113

2105

No

Write 1 Into Output FIFO

2116

FIFO

B

2115

2106

c Inside Limits for Space? — Yes

Write 0 Into Output FIFO

No

2117

Display Error

A

B

2107

Stop (Sleep)

2118

2119

2108

**Figure 21**

2201

2207

Start (Interrupt)

2202

Samples in FIFO?          No

2208

Yes

FIFO

Read a
Sample x from
FIFO

2203

2209

First Loop?          No

Yes

2210

Display Error

2211

Stop (Sleep)

2204

x a Mark (1)?          Yes

2212

Mark (1)
Wave
Table

Copy n Entries
from Mark (1)
Wave Table to
Output FIFO

No

2213

A

2214

2216

Space (0)
Wave
Table

Copy n Entries
from Space (0)
Wave Table to
Output FIFO

FIFO

2205

A

2215

2206

**Figure 22**